(19) Europäisches Patentamt
European Patent Office
Office européen des brevets

(11) EP 3 006 825 A1

(12) EUROPEAN PATENT APPLICATION
published in accordance with Art. 153(4) EPC

(43) Date of publication:
13.04.2016 Bulletin 2016/15

(51) Int Cl.:
F21V 29/87 (2015.01)    F21V 29/00 (2015.01)
F21V 19/00 (2006.01)    F21Y 115/10 (2016.01)

(21) Application number: 14803887.0

(22) Date of filing: 26.05.2014

(86) International application number:
PCT/JP2014/002762

(87) International publication number:
WO 2014/192280 (04.12.2014 Gazette 2014/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 29.05.2013 JP 2013112782
12.09.2013 JP 2013189347
17.10.2013 JP 2013216180

(71) Applicant: Panasonic Intellectual Property
Management Co., Ltd.
Osaka-shi, Osaka 540-6207 (JP)

(72) Inventors:
• KUSUNOKI, Tomokazu
Osaka 540-6207 (JP)
• YODEN, Hiroyoshi
Osaka 540-6207 (JP)
• KOTANI, Yuki
Osaka 540-6207 (JP)
• KOTERA, Ryusuke
Osaka 540-6207 (JP)

(74) Representative: Müller-Boré & Partner
Patentanwälte PartG mbB
Friedenheimer Brücke 21
80639 München (DE)

(54) LED UNIT

(57) An LED unit (100) includes a base unit (1). The LED unit further includes a light emitting device (3) including: a package substrate (3b); and a light emitting portion (3a) provided in the package substrate and having LED chips, the light emitting device being placed on a front surface of the base unit. The base unit is fonned of a molding in which a metal member (11) is covered with thermally conductive resin having an electrical insulation property, and the thermally conductive resin is interposed between the light emitting device and the metal member. The LED unit can thus efficiently radiate heat generated in the light emitting device through the base unit toward a fixture to which the LED unit is attached.

FIG. 4

EP 3 006 825 A1

EP 3 006 825 A1

**Description**

TECHNICAL FIELD

The present invention relates to LED units. More particularly, the present invention relates to an LED unit having high thermal radiation and electrical insulation properties.

BACKGROUND ART

LED units are now being used in light fixtures using long-life light emitting diodes (LEDs) with low power consumption. When an LED unit turns on, however, a light emitting portion in an LED substrate generates heat, which decreases light emitting efficiency of a light fixture. In order to radiate heat generated in the LED substrate, it has been proposed that a material having high thermal conductivity is used in a member on which the LED substrate is mounted (for example, refer to Patent Literatures 1 to 3).

Patent Literature 1 teaches that a member formed of a material having high thermal conductivity including metal such as aluminum, copper and stainless steel or ceramics is used in a base unit on which an LED substrate is mounted. When metal is used in the base unit, however, electrical insulation should be ensured between the LED substrate and the base unit. Thus, Patent Literature 1 further teaches that a thermally conductive sheet having thermal conduction and electrical insulation properties is placed between the LED substrate and the base unit.

CITATION LIST

PATENT LITERATURE

Patent Literature 1: Japanese Unexamined Patent Application Publication No. 2012-182192
Patent Literature 2: Japanese Unexamined Patent Application Publication No. 2012-133964
Patent Literature 3: Japanese Unexamined Patent Application Publication No. 2012-199256

SUMMARY OF INVENTION

The thermally conductive sheet described in Patent Literature 1 is required to have a predetermined thickness in order to ensure sufficient electrical insulation performance. However, the thermal conductivity of the thermally conductive sheet may decrease when the thickness of the thermally conductive sheet increases. Under such circumstances, there has been a demand for development of LED units having both heat radiation and electrical insulation properties.

The present invention has been made in view of the above-described conventional problem. An object of the present invention is to provide an LED unit having a high heat radiation property while exerting electrical insulation performance on an LED substrate.

An LED unit according to an aspect of the present invention includes a base unit, and a light emitting device including: a package substrate; and a light emitting portion provided in the package substrate and having an LED chip, the light emitting device being placed on a front surface of the base unit. The base unit is formed of a molding in which a metal member is covered with thermally conductive resin having an electrical insulation property, and the thermally conductive resin is interposed between the light emitting device and the metal member.

BRIEF DESCRIPTION OF DRAWINGS

[Fig. 1] Fig. 1 is an exploded perspective view showing an LED unit according to first to third embodiments of the present invention.
[Fig. 2] Fig. 2 is a perspective view showing the LED unit according to the embodiments of the present invention.
[Fig. 3] Fig. 3(a) is a plan view showing the LED unit according to the first to third embodiments, and Fig. 3(b) is a bottom view showing the LED unit according to the first to third embodiments.
[Fig. 4] Fig. 4 is a cross-sectional view showing an example of the LED unit according to the first embodiment. Fig. 4(a) is a cross-sectional view taken along line A-A' of Fig. 3, and Fig. 4(b) is a cross-sectional view taken along line B-B' of Fig. 3.
[Fig. 5] Fig. 5 is a schematic view showing a constitution of thermally conductive resin which can be used for a base unit and an insulation and heat radiation moulding in the LED unit according to the embodiments of the present invention. Fig. 5(a) is a schematic view of the thermally conductive resin, and Fig. 5(b) is a partially enlarged view of the thermally conductive resin.

[Fig. 6] Fig. 6 is a microphotograph of the thermally conductive resin which can be used for the base unit and the insulation and heat radiation moulding.

[Fig. 7] Fig. 7 is a cross-sectional view showing the LED unit according to the second embodiment. Fig. 7(a) is a cross-sectional view taken along line A-A' of Fig. 3, and

Fig. 7(b) is a cross-sectional view taken along line B-B' of Fig. 3.

[Fig. 8] Fig. 8 is a cross-sectional view showing the LED unit according to the third embodiment. Fig. 8(a) is a cross-sectional view taken along line A-A' of Fig. 3, and

Fig. 8(b) is a cross-sectional view taken along line B-B' of Fig. 3.

[Fig. 9] Fig. 9 is an exploded perspective view showing an LED unit according to a fourth embodiment of the present invention.

[Fig. 10] Fig. 10 is a cross-sectional view showing an example of the LED unit according to the fourth embodiment. Fig. 10(a) is a cross-sectional view taken along line A-A' of Fig. 3, and Fig. 10(b) is a cross-sectional view taken along line B-B' of Fig. 3.

[Fig. 11] Fig. 11 is a schematic cross-sectional view showing a heat radiator of an LED unit according to a fifth embodiment.

[Fig. 12] Fig. 12 is a schematic cross-sectional view showing a heat radiator of an LED unit according to a sixth embodiment.

## DESCRIPTION OF EMBODIMENTS

Hereinafter, LED units according to embodiments of the present invention will be explained in detail below. It should be noted that dimensional ratios in the drawings are magnified for convenience of explanation and may be different from actual ratios.

[First embodiment]

<Configuration of LED unit>

An LED unit 100 according to the present embodiment includes a base unit 1. The LED unit 100 further includes a light emitting device 3 including: a package substrate 3b; and a light emitting portion 3a provided on the package substrate 3b and having LED chips, the light emitting device 3 being placed on the front surface of the base unit 1. The base unit 1 is formed of a molding in which a metal member is covered with thermally conductive resin having an electrical insulation property. The thermally conductive resin is interposed between the light emitting device 3 and the metal member 11.

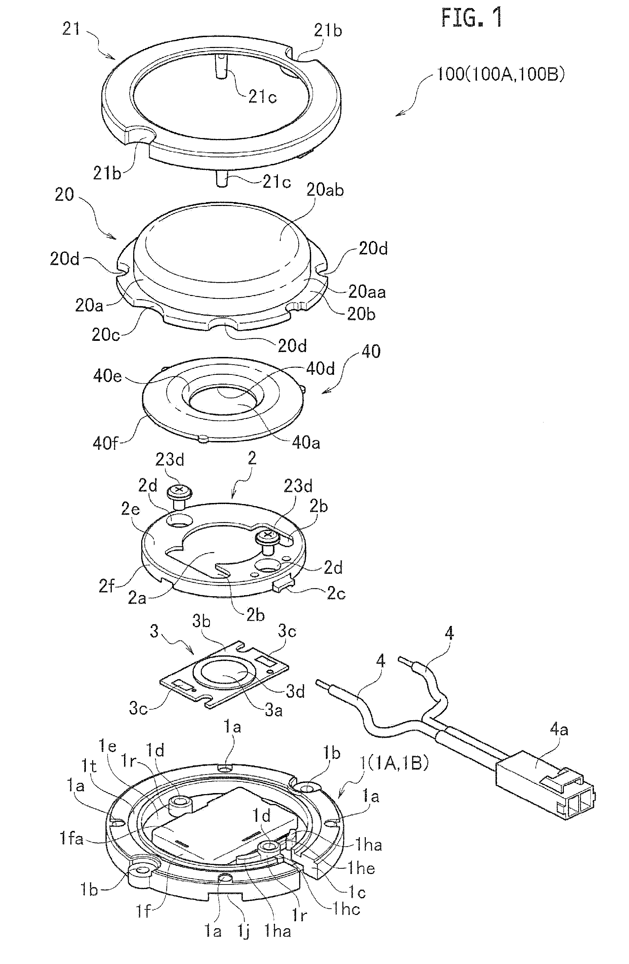

As shown in Fig. 1, the LED unit 100 according to the present embodiment includes the base unit 1 having a disk-like shape, and the light emitting device 3 placed on the front surface of the base unit 1. The light emitting device 3 is provided, on one surface of the package substrate 3b, with the light emitting portion 3a having LED chips and terminal portions 3c for supplying power to the light emitting portion 3a. The other surface of the package substrate 3b is placed to face the base unit 1.

The LED unit 100 includes a holder 2 placed on the light emitting device 3 on the opposite side of the base unit 1 with the package substrate 3b held between the holder 2 and the base unit 1. The LED unit 100 further includes a cover 20 and a cover holding member 21 placed on the holder 2 on the opposite side of the base unit 1 and fixed to the base unit 1. The holder 2 has a window hole 2a through which light emitted from the light emitting device 3 is extracted. The cover 20 functions to transmit light emitted from the light emitting device 3.

The LED unit 100 includes two assembling screws 23d inserted into screw insertion holes 2d provided in the holder 2 to connect the holder 2 with the base unit 1. The LED unit 100 further includes electric wires 4 for supplying power electrically connected to the respective terminal portions 3c.

The light emitting device 3 includes the light emitting portion 3a including a plurality of LED chips and the package substrate 3b on which the light emitting portion 3a is mounted. The light emitting portion 3a includes the plural LED chips and a sealing portion 3d covering the plural LED chips. The LED chips used may be blue LED chips. The sealing portion 3d may have a configuration in which a yellow phosphor excited by blue light emitted from the blue LED chips to emit yellow light, is mixed in a transparent sealing material. Accordingly, white light can be obtained from the light emitting device 3.

The package substrate 3b is formed, for example, by use of a metal-based printed circuit board. The package substrate 3b has a rectangular shape in a plan view and is configured such that the dimension in the longitudinal direction is smaller than the outer dimension of the circular base unit 1. The package substrate 3b is provided with the terminal portions 3c electrically connected to the light emitting portion 3a. The respective terminal portions 3c are electrically connected with the electric wires 4 via connecting portions formed of solder. One of the electric wires 4 is connected to the terminal portion 3c connected to a plus side of the light emitting portion 3a (the terminal portion 3c on the left in Fig. 1), and the other electric wire 4 is connected to the terminal portion 3c connected to a minus side of the light emitting portion 3a (the terminal portion 3c on the right in Fig 1).

The base unit 1 is provided, on the front surface, with a circular recessed portion 1e in which part of the respective electric wires 4 connected to the light emitting device 3 is stored. A protruding base portion 1f is provided in the middle of an inner bottom surface of the recessed portion 1e. A front end surface 1fa of the protruding base portion 1f faces the other surface of the package substrate 3b.

The protruding base portion 1f is formed into a rectangular shape in a plan view larger than the package substrate 3b of the light emitting device 3. In the LED unit 100, the center of the protruding base portion 1f is located in the center of the base unit 1 in a manner such that the center of the protruding base portion 1f conforms to the center of the light emitting device 3. Namely, the LED unit 100 has a configuration in which the optical axis of the light emitting device 3 conforms to the central line of the base unit 1 extending in the thickness direction thereof.

The base unit 1 is provided, on the inner bottom surface of the recessed portion 1e, with cylindrical bosses 1r on both sides of the protruding base portion 1f in the short-side direction. Each of the bosses 1r is provided with a screw hole 1d into which the assembling screw 23d is fitted.

A circumferential edge of the base unit 1is provided with screw insertion holes 1b into which fixing screws for fixing the LED unit 100 to a light fixture (not shown in the drawings) are inserted. The base unit 1 includes the two screw insertion holes 1b separated from each other in the circumferential direction of the base unit 1. The fixing screws are inserted into the screw insertion holes 1b from the front surface side of the base unit 1.

In the present embodiment, a thermal interface material (TIM) 50 is applied between the package substrate 3b and the protruding base portion 1f in order to improve thermal conductivity between the light emitting device 3 and the base unit 1. Examples of the thermal interface material include silicone-based grease and poly-α-olefin-based grease. The thermal interface material used is more preferably a high thermal-conducting material in view of heat radiation.

The holder 2 includes an upper wall portion 2e holding the package substrate 3b of the light emitting device 3 between the upper wall portion 2e and the protruding base portion 1f. The holder 2 further includes a circumferential wall portion 2f extending from the circumference of the upper wall portion 2e toward the base unit 1. The upper wall portion 2e of the holder 2 has a disk-like shape and is provided with the window hole 2a in the middle thereof to which the light emitting portion 3a of the light emitting device 3 is exposed. The inner diameter of the window hole 2a is greater than the outer diameter of the circular light emitting portion 3a.

The holder 2 includes slits 2b formed at portions where the respective electric wires 4 are positioned at the circumferential edge of the upper wall portion 2e. The respective slits 2b prevent the electric wires 4 connected to the terminal portions 3c of the light emitting device 3 from interfering with the upper wall portion 2e. The respective slits 2b communicate with the window hole 2a.

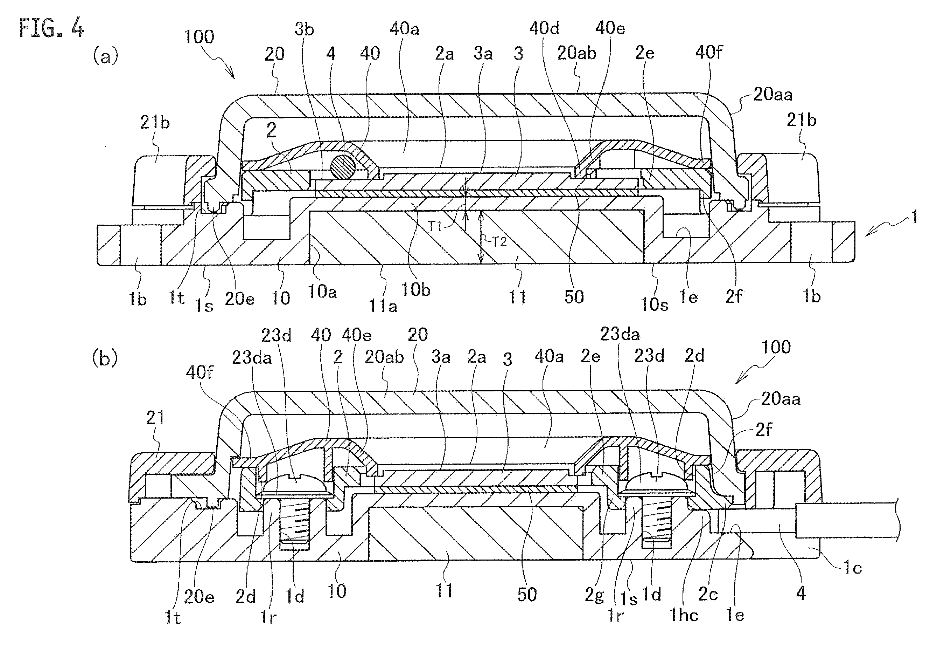

The holder 2 is provided with bosses 2g corresponding to the screw holes 1d of the base unit 1 and projecting toward the base unit 1 (refer to Fig. 4(b)). The screw insertion holes 2d into which the assembling screws 23d are inserted are formed to penetrate the respective bosses 2g. Here, the opening of the respective screw insertion holes 2d has a circular shape. The screw insertion holes 2d each have a first inner diameter in the upper wall portion 2e on the opposite side of the base unit 1 that is slightly greater than the outer diameter of a head portion 23da of each assembling screw 23d. The screw insertion holes 2d each have a second inner diameter on the base unit 1 side that is smaller than the outer diameter of the head portion 23da of each assembling screw 23d.

In the LED unit 100 according to the present embodiment, tips of the bosses 1r of the base unit 1 are inserted into part of the screw insertion holes 2d having the second inner diameter in the bosses 2g of the holder 2. The base unit 1 has a rib 1hc integrated with one of the bosses 1r (the boss 1r on the right in Fig. 1 and Fig. 4(b)) that restricts the inserted amount of the holder 2 toward the base unit 1.

The base unit 1 is further provided, at the circumferential edge thereof, with a leading portion 1c for leading the electric wires 4 electrically connected to the light emitting device 3 to the outside of the LED unit 100. The leading portion 1c formed at the circumferential edge of the base unit 1 is a notch at which the direction in which the electric wires 4 are led to the outside of the LED unit 100 can be changed.

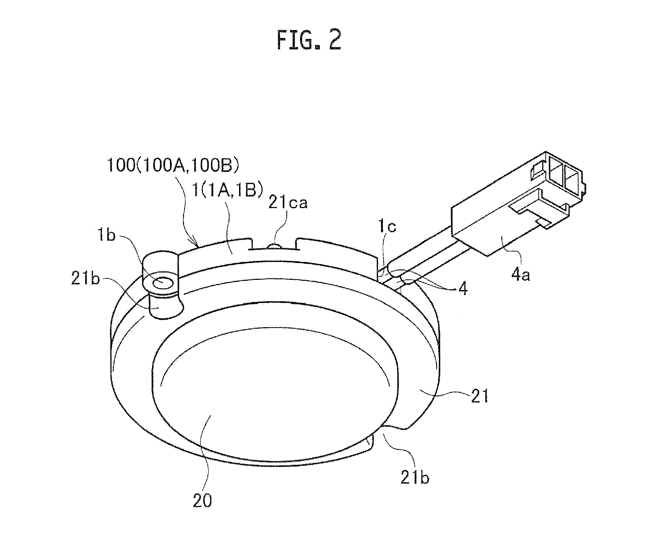

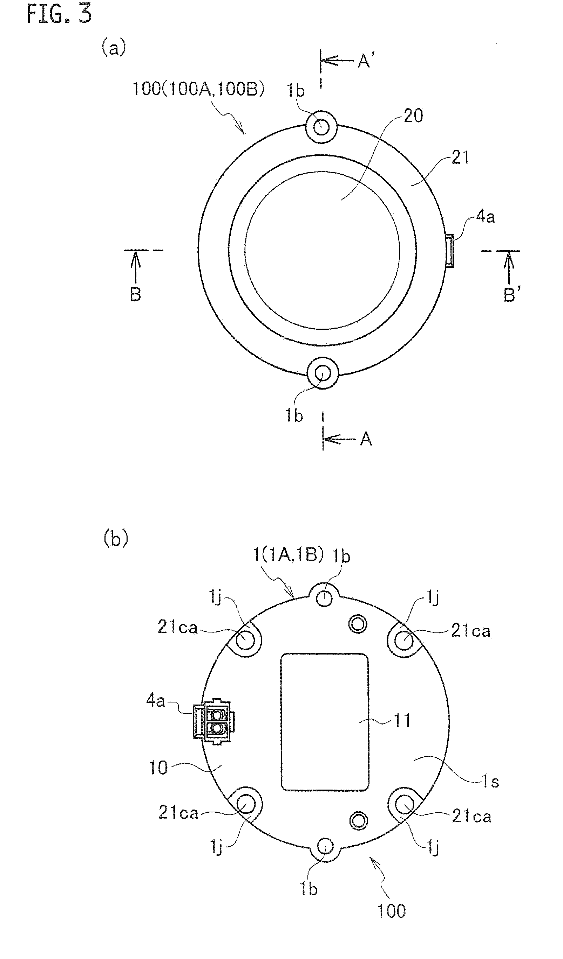

The leading portion 1c is formed at the circumferential edge of the base unit 1 in a manner such that the front surface, the rear surface and the side surface of the base unit 1 are open. Here, the cover holding member 21 is placed at the circumferential edge of the base unit 1 on the front surface side. Thus, the LED unit 1 can change the direction in which the electric wires 4 are led to the outside of the LED unit 100 through the leading portion 1c between the direction along the rear surface 1s of the base unit 1 as shown in Fig. 2 and the direction perpendicular to the rear surface 1s as shown in Fig. 3.

The inner bottom surface of the recessed portion 1e of the base unit 1 is provided with ribs 1ha located adjacent to the leading portion 1c to hold the electric wires 4 between the ribs 1ha and the inner circumferential surface of the recessed portion 1e. The two ribs 1ha are connected to each other via connection pieces the formed on the inner bottom surface of the recessed portion 1e of the base unit 1. These members can keep the respective electric wires 4 electrically connected to the light emitting device 3 inside the base unit 1 so as to serve as a tension stopper with no additional component used.

The holder 2 is provided, at the circumferential wall portion 2f adjacent to the leading portion 1c of the base unit 1, with a holding portion 2c for holding the electric wires 4 between the holding portion 2c and the base unit 1. Thus, the electric wires 4 electrically connected to the light emitting device 3 can be held between the holding portion 2c of the holder 2 and the base unit 1.

The cover 20 is formed of a translucent material. The cover 20 includes a body portion 20a open toward the base unit 1 and covering the light emitting device 3 and other members on the inner side of the outer circumferential edge of the base unit 1. The cover 20 further includes a flange 20b projecting outward from an opening edge of the body portion 20a to attach the cover 20 to the base unit 1. The body portion 20a includes a cylindrical portion 20aa having a cylindrical shape and a light radiating portion 20ab having a circular shape and covering the cylindrical portion 20aa on one side most distant from the base unit 1. The light can be emitted from the light emitting device 3 to the outside through the light radiating portion 20ab. The body portion 20a is formed in a manner such that the cylindrical portion 20aa is smoothly integrated with the light radiating portion 20ab.

The cover 20 is provided, on the holder 2 side, with a ring-shaped inner cover 40 that covers the assembling screws 23d inserted into the respective screw insertion holes 2d of the holder 2 and the electric wires 4 exposed to the respective slits 2b of the holder 2. The inner cover 40 is formed of a non-translucent material and housed in the body portion 20a of the cover 20.

The cover 20 is provided with a ring-like rib 20e (refer to Fig. 4) on the surface of the flange 20b facing the base unit 1. The base unit 1 is provided with a ring-like groove 1t at a position corresponding to the rib 20e so as to house the rib 20e. The groove 1t communicates with the leading portion 1c. In the LED unit 100, the width dimension of the ring-like groove 1t is greater than the width dimension of the ring-like rib 20e. A gap defined by the inner surface of the groove 1t, the flange 20b and the rib 20e of the cover 20 is sealed with a sealing portion formed of a sealing material for airtight sealing. Accordingly, the LED unit 100 can be protected against entrance of moisture or impurities.

The inner cover 40 has a circular open window 40a. The area of the opening of the open window 40a on the side closer to the light emitting device 3 is substantially the same as the area of the light emitting portion 3a. In the other part of the opening, the area of the opening gradually increases as the distance from the light emitting device 3 increases in the direction of the optical axis of the light emitting device 3. The inner cover 40 includes a small-diameter portion 40d having the smallest inner diameter and brought into contact with the one surface of the package substrate 3b. The inner cover 40 is provided with a tapered portion 40e integrated with the small-diameter portion 40d and having an inner diameter that gradually increases as the distance from the small-diameter portion 40d increases in the thickness direction of the package substrate 3b. The inner cover 40 includes a contact portion 40f at the circumferential edge thereof that comes into contact with the circumferential edge of the holder 2.

The cover holding member 21 is formed of a non-translucent material. The cover holding member 21 is formed into a flat ring-like shape so as not to block the light emitted from the light emitting device 3 and radiated from the body portion 20a of the cover 20 as much as possible. The cover holding member 21 is placed to hold the flange 20b of the cover 20 between the cover holding member 21 and the base unit 1.

The cover holding member 21 is provided, on the surface facing the base unit 1, with a plurality of cylindrical bosses 21c projecting toward the base unit 1. The cover 20 is provided with semicircular notches 20d at the outer circumferential edge of the flange 20b at portions corresponding to the respective bosses 21c of the cover holding member 21 so that the respective bosses 21 c are inserted therethrough. The base unit 1 is provided with penetration holes 1a at the circumferential edge thereof at portions corresponding to the respective bosses 21 c of the cover holding member 21 so that the bosses 21c are inserted thereinto.

When the cover 20 is attached to the base unit 1, the respective bosses 21 c of the cover holding member 21 are first inserted into the corresponding penetration holes 1a of the base unit 1. Subsequently, tips of the bosses 21c are irradiated with a laser beam or the like from the rear surface 1s of the base unit 1 and subjected to plastic deformation so as to have a shape wider than the penetration holes 1a. The cover holding member 21 is thus fixed to the base unit 1, and the cover 20 is attached to the base unit 1. Consequently, the bosses 21 c are formed into a mushroom shape.

As shown in Fig. 3(b), the rear surface 1s of the base unit 1 is provided with housing portions 1j into which head portions 21ca of the mushroom-shaped bosses 21c are housed at positions corresponding to the respective penetration holes 1a. The housing portions 1j communicate with the corresponding penetration holes 1a. The depth dimension of the respective housing portions 1j is configured such that the head portions 21ca of the bosses 21c do not project from the rear surface 1s of the base unit 1.

The cover holding member 21 is provided, at the outer circumferential edge thereof, with notches 21b through which the fixing screws (not shown in the drawings) are inserted at portions corresponding to the respective screw insertion holes 1b of the base unit 1. The flange 20b of the cover 20 is provided, at the outer circumferential edge thereof, with notches 20c through which the fixing screws are inserted at portions corresponding to the respective screw insertion holes 1b and notches 21b. The notches 21b of the cover holding member 21 and the notches 20c of the cover 20 are each formed into a semicircular shape. Thus, the LED unit 100 can be fixed to the light fixture with the base unit 1 attached thereto from the cover 20 side.

In the LED unit 100, one end of each electric wire 4 is connected to each terminal portion 3c of the light emitting device 3, and the other end is connected to a connector 4a. The connector 4a is detachably connected to a power source.

<Configuration of base unit>

The base unit 1 used in the LED unit 100 according to the first embodiment includes, as shown in Fig. 4, a unit body 10 formed of the thermally conductive resin and the metal member 11 placed inside the unit body 10.

The unit body 10 is provided with, as described above, the circular recessed portion 1e on the front surface thereof and the protruding base portion 1f in the middle of the bottom surface of the recessed portion 1e. The package substrate 3b of the light emitting device 3 is placed on the front end surface 1 fa of the protruding base portion 1 f. The unit body 10 is further provided, on the rear surface 1s, with a concavity 10a into which the metal member 11 is inserted. The concavity 10a is formed substantially into a rectangular parallelepiped conforming to the metal member 11.

The metal member 11 is formed substantially into a rectangular parallelepiped, as shown in Fig. 4. The protruding base portion 1f to which the light emitting device 3 is fixed is also formed substantially into a rectangular parallelepiped, as shown in Fig. 1 and Fig. 4. The metal member 11 formed substantially into a rectangular parallelepiped thus conforms to the protruding base portion 1f in order to improve the performance of heat radiation from the light emitting device 3.

The unit body 10 is formed of the thermally conductive resin. Therefore, the electrical insulation between the light emitting device 3 and the metal member 11 can be ensured without use of a thermally conductive sheet having an electrical insulation property, which has been used in the known technology. The thermally conductive resin that can be used for the unit body 10 preferably has thermal conductivity of 1.5 W/m·K or greater. The use of such resin can enhance the performance of heat radiation from the light emitting device 3 toward the metal member 11 so as to improve the light emitting efficiency of the light emitting device 3. The upper limit of the thermal conductivity of the thermally conductive resin is not particularly limited but may be set to 10 W/m·K. Although resin having high thermal conductivity does not have a problem with heat radiation performance, moldability thereof may deteriorate because of insufficient resin fluidity. For this reason, the thermal conductivity of the thermally conductive resin included in the unit body 10 is preferably set in the range of 1.5 to 10 W/m·K.

The thermally conductive resin used is preferably the resin described below. The resin described below can efficiently radiate heat from the light emitting device 3 toward the metal member 11 since the thermal conductivity thereof is 1.5 W/m·K or greater.

Any metal may be used as a material included in the metal member 11 as long as it can sufficiently radiate heat generated in the light emitting device 3. In order to further enhance the heat radiation performance, the metal included in the metal member 11 preferably has thermal conductivity of 50 W/m·K or greater. Such metal can increase the heat radiation performance of the base unit 1 so as to improve the light emitting efficiency of the light emitting device 3. The upper limit of the thermal conductivity of the metal included in the metal member 11 is not particularly limited but may be set to 400 W/m·K. Metal having high thermal conductivity does not have a problem with heat radiation performance but tends to be a high-cost substance which is not easily available and may have difficulty with processability. For this reason, the thermal conductivity of the metal included in the metal member 11 is preferably set in the range of 50 to 400 W/m·K. In order to further improve the heat radiation performance, the thermal conductivity of the metal included in the metal member 11 is more preferably set in the range of 100 to 400 W/m·K.

Examples of the metal having the thermal conductivity of 50 W/m·K or greater include aluminum, copper, iron, chromium, nickel, manganese, and stainless steel. These metals may be used alone or in combination of two or more thereof. An alloy of any of these metals and other metal may be used instead. The metal member 11 including such metal may be subjected to surface treatment to be protected against abrasion and improve adhesion to the thermally conductive resin. In particular, the metal member 11 may be covered with an anodized aluminum film. Alternatively, the metal member 11 may be subjected to surface treatment with a metal coupling agent to be covered with a metal oxide film.

As described above, the metal member 11 is inserted into the concavity 10a of the unit body 10. The metal member 11 is thus covered with the thermally conductive resin excluding a rear surface 11 a. The front surface and the side surface of the metal member 11 excluding the rear surface 11 a are in contact with the inner surface of the concavity 10a of the unit body 10. A resin layer 10b is interposed between the package substrate 3b of the light emitting device 3 and the metal member 11. Accordingly, the electrical insulation between the light emitting device 3 and the metal member 11 can be ensured due to the resin layer 10b interposed therebetween.

Thickness T1 of the resin layer 10b in the stacked direction of the base unit 1 and the light emitting device 3 is not particularly limited as long as the electrical insulation property can be ensured but is preferably set in the range of 0.3 mm or greater to 1 mm or less. The resin layer 10b with the thickness in this range can prevent a decrease in thermal conductivity while exerting the electrical insulation performance on the light emitting device 3. Here, the thickness T1 of the resin layer 10b in the base unit 1 according to the present embodiment is set to 0.5 mm.

Thickness T2 of the metal member 11 in the stacked direction of the base unit 1 and the light emitting device 3 is not particularly limited. However, in view of strength, heat radiation performance and processability of the metal member 11, the thickness T2 of the metal member 11 is preferably set in the range of 1 mm or greater to 6 mm or less.

The rear surface 11 a of the metal member 11 is preferably exposed on the rear surface 1s of the base unit 1 in the present embodiment. The heat generated in the light emitting device 3 is transmitted to the rear surface 11 a through the resin layer 10b of the unit body 10 and the metal member 11. Thus, the transmitted heat can be radiated toward the light fixture (not shown in the drawings) in contact with the rear surface 11a. Accordingly, a decrease in light emitting efficiency of the light emitting device 3 can reliably be suppressed.

The rear surface 10s of the unit body 10 and the rear surface 11a of the metal member 11 are preferably positioned on the same plane. Alternatively, the rear surface 11a of the metal member 11 preferably projects from the rear surface 10s of the unit body 10 on the opposite side of the light emitting device 3. Accordingly, the rear surface 11a of the metal member 11 is easily brought into contact with the light fixture to which the LED unit 100 is fixed so as to improve the heat radiation performance.

A breakdown voltage between the front surface and the rear surface 1s of the base unit 1 according to the present embodiment is preferably 5 kV/mm or greater. The breakdown voltage of 5 kV/mm or greater can prevent a short circuit between the light emitting device 3 and the metal member 11 and prevent a malfunction or abnormal heat generation of the light emitting device 3. The upper limit of the breakdown voltage of the base unit 1 is not particularly limited but may be set to 40 kV/mm or less. The breakdown voltage of the base unit 1 may be measured in accordance with Japanese Industrial Standards JIS C2110-1 (Solid electrical insulating materials-Test methods for electric strength-Part 1: Tests at power frequencies).

The area of the metal member 11 in the stacked direction of the base unit 1 and the light emitting device 3 is preferably larger than the area of the package substrate 3b of the light emitting device 3. The heat generated in the light emitting device 3 is thus easily transmitted toward the metal member 11 so that a decrease in light emitting efficiency can be suppressed more reliably.

<Thermally conductive resin>

As described above, the unit body 10 included in the base unit 1 according to the present embodiment is formed of the thermally conductive resin. The thermally conductive resin preferably not only has thermal conduction and electrical insulation properties but also exhibits high moldability. Examples of the thermally conductive resin having such characteristics include resin showing crystallinity or liquid crystallinity and composite resin obtained in a manner such that thermosetting resin or thermoplastic resin is filled with inorganic filler having high thermal conductivity. These thermally conductive resins may be used alone or in combination of two or more thereof.

Examples of the thermosetting resin include epoxy resin, unsaturated polyester resin, vinyl ester resin, phenolic resin, urethane resin, urea resin, and melamine resin. Other examples of the thermosetting resin include maleimide resin, cyanate ester resin, alkyd resin, addition-curing polyimide resin, silicone resin, and a thermosetting elastomer (such as silicone rubber, urethane rubber, and fluororubber). These thermosetting resins may be used alone or in combination of two or more thereof. Among these, epoxy resin is particularly preferable because of high adhesion, heat resistance, electrical insulation performance and mechanical property.

The epoxy resin used as the thermosetting resin may be conventionally-known epoxy resin. Examples thereof include bisphenol A epoxy resin, bisphenol F epoxy resin, bisphenol S epoxy resin, biphenyl epoxy resin, naphthalenediol epoxy resin, and phenol novolac epoxy resin. Other examples include cresol novolac epoxy resin, bisphenol A novolac epoxy resin, cyclic aliphatic epoxy resin, and heterocyclic epoxy resin (such as triglycidyl isocyanurate and diglycidylhydantoin). Further, modified epoxy resin obtained in a manner such that any of these epoxy resins is modified with various kinds of materials may be used. A halide such as a bromine compound or a chlorine compound of these epoxy resins may also be used. These epoxy resins may be used alone or in combination of two or more thereof.

A curing agent for curing the epoxy resin may be any compound as long as it has an active group that can react with an epoxy group. Although conventionally-known epoxy curing agents may be used as appropriate, a compound having an amino group, an acid anhydride group or a hydroxyphenyl group is particularly suitably used. Examples of the compound include dicyandiamide and a derivative thereof, an organic acid hydrazide, an amine imide, an aliphatic amine, an aromatic amine, a tertiary amine, salt of a polyamine, a microcapsule-type curing agent, an imidazole-based curing agent, an acid anhydride, and phenol novolac. These curing agents may be used alone or in combination of two or more thereof.

Various types of curing promotors may be used in combination with the curing agent described above. When the epoxy resin is used as the thermosetting resin, a curing promotor used may be a tertiary amine-based curing promotor, a urea derivative-based curing promotor, an imidazole-based curing promotor, or a diazabicycloundecene-based (DBU) curing promotor. Other examples thereof include an organic phosphor-based curing promotor (such as a phosphine-based curing promotor), an onium salt-based curing promotor (such as a phosphonium salt-based curing promotor, a sulfonium salt-based curing promotor, an ammonium salt-based curing promotor). Further, a metal chelate-based curing promotor, an acid-based curing promotor, and a metallic salt-based curing promotor may also be used.

Thermoplastic resin generally has, in a principal chain, at least one bond selected from the group consisting of a carbon-carbon bond, an amide bond, an imide bond, an ester bond, and an ether bond. The thermoplastic resin may also have, in the principal chain, at least one bond selected from the group consisting of a carbonate bond, a urethane bond, a urea bond, a thioether bond, a sulfone bond, an imidazole bond, and a carbonyl bond.

As the thermoplastic resin, for example, there are mentioned: a polyolefin-based resin; a polyamide-based resin; a thermoplastic elastomer-based (styrene-based, olefin-based, polyvinyl chloride (PVC)-based, urethane-based, ester-based, and amide-based) resin; an acrylic resin; a polyester-based resin; and the like. Moreover, there are mentioned: engineering plastics; polyethylene; polypropylene; a Nylon resin; an acrylonitrile-butadiene-styrene (ABS) resin; an ethylene acrylate resin; an ethylene vinyl acetate resin; and a polystyrene resin. Furthermore, there are also mentioned: a polyphenylene sulfide resin; a polycarbonate resin; a polyester elastomer resin; a polyamide elastomer resin; a liquid crystal polymer; a polybutylene terephthalate resin; and the like. As the thermoplastic resin, one of these resins may be used singly, or two or more thereof may be used in combination.

Examples of an inorganic compound having both heat radiation and electrical insulation properties and forming inorganic filler include a boride, carbide, a nitride, an oxide, a silicide, a hydroxide, and a carbonate. More specific examples include magnesium oxide (MgO), aluminum oxide ($Al_2O_3$), boron nitride (BN), aluminum nitride (AlN), and aluminum hydroxide (Al(OH)$_3$). Other examples thereof include silicon dioxide ($SiO_2$), magnesium carbonate ($MgCO_3$), magnesium hydroxide (Mg(OH)$_2$), calcium carbonate ($CaCO_3$), clay, talc, mica, titanium oxide ($TiO_2$), and zinc oxide (ZnO). In view of thermal conductivity, MgO, $Al_2O_3$, BN and AlN are preferably used.

In order to improve compatibility with the resin, the inorganic filler may be subjected to surface treatment such as coupling treatment or added with a dispersant so as to enhance dispersion into the resin.

An organic surface treatment agent such as a fatty acid, fatty acid ester, higher alcohol and hydrogenated oil may be used for the surface treatment. An inorganic surface treatment agent such as silicone oil, a silane coupling agent, an alkoxysilane compound and a silylation agent may also be used for the surface treatment. The use of such a surface treatment agent may increase water resistance and further enhance the dispersion into the resin. The treatment method is not particularly limited but may be a dry method, a wet method, or an integral blending method.

The thermally conductive resin may contain a colorant, a flame retardant, a flame-retardant assistant, a fiber reinforcing agent, a viscosity reducer for adjusting viscosity during manufacture, a dispersion adjuster for improving dispersion of toner (colorant), and a mold release agent as long as they do not impair the effects of the present embodiment. These agents may be conventionally-known ones, but specific examples thereof may be as follows.

The colorant may be an inorganic pigment such as titanium oxide, an organic pigment, or toner mainly containing the inorganic or organic pigment. These colorants may be used alone or in combination of two or more thereof.

Examples of the flame retardant include an organic flame retardant, an inorganic flame retardant, and a reaction flame retardant. These flame retardants may be used alone or in combination of two or more thereof. When the resin contains the flame retardant, a flame-retardant assistant is preferably used together. As the flame-retardant assistant, there are mentioned: an antimony compound such as diantimony trioxide, diantimony tetraoxide, diantimony pentoxide, sodium antimonate, antimony tartrate; zinc borate; barium metaborate; and the like. Moreover, hydrated alumina, zirconium oxide, ammonium polyphosphate, tin oxide, iron oxide and the like are also mentioned. These flame-retardant assistants may be used alone or in combination of two or more thereof.

A kneading machine used for producing the thermally conductive resin may be a conventionally-known machine. Specific examples thereof include a roll mill, a planetary mixer, a kneader, an extruder, a Banbury mixer, a mixing container having a stirring blade, and a lateral-type mixing tank.

The unit body 10 may also include thermally conductive resin containing highly thermally conductive filler. The highly thermally conductive filler is preferably inorganic filler having an electrical insulation property. In the unit body 10, thermally conductive resin 60 added with inorganic filler described below with thermal conductivity greatly improved is preferably used.

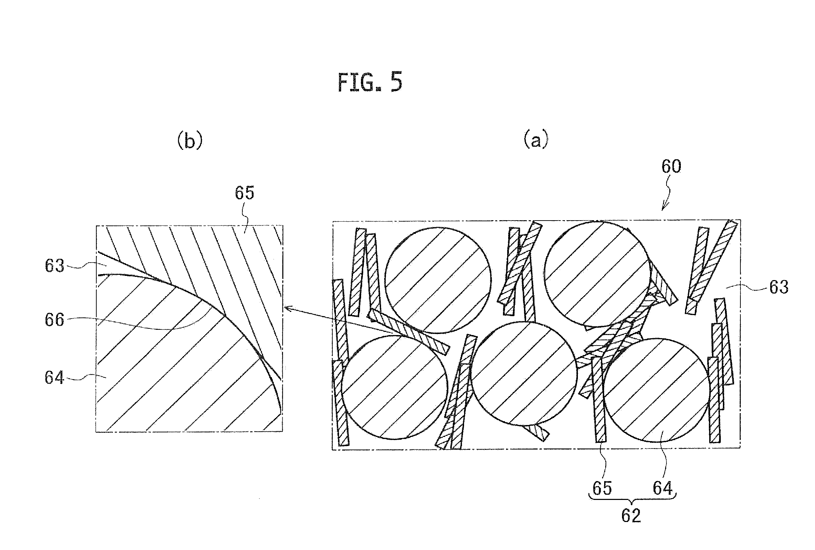

As shown in Fig. 5, the thermally conductive resin 60 contains thermally conductive filler 62 and binder resin 63. The thermally conductive filler 62 contains hard filler 64 having Mohs hardness of 5 or greater and soft filler 65 having Mohs hardness of 3 or less.

The thermally conductive resin 60 is obtained in a manner such that the thermally conductive filler 62 is dispersed in the binder resin 63 so as to increase thermal conductivity. The thermally conductive resin 60 contains the thermally conductive filler 62 which is a combination of the hard filler 64 and the soft filler 65. The use of the two types of fillers having different levels of Mohs hardness improves a contact rate therebetween so as to increase thermal conduction paths. In particular, as shown in Fig. 5(a) and Fig. 5(b), the soft filler 65 is pressed by the hard filler 64 when the thermally conductive resin 60 is produced so that the soft filler 65 is deformed at a contact portion 66 between the hard filler 64 and the soft filler 65. The hard filler 64 and the soft filler 65 come in surface contact with each other so as to increase widths of the thermal conduction paths. Accordingly, the thermally conductive resin 60 using the hard filler 64 together with the soft filler 65 can improve the thermal conductivity more efficiently than the thermally conductive resin 60 using the hard filler 64 alone when the amount of fillers is the same.

More particularly, when the thermally conductive resin 60 is molded and solidified, the soft filler 65 is pressed by the hard filler 64 in the binder resin 63 so that the surface of the soft filler 65 is curved along the surface of the hard filler 64. As a result, the hard filler 64 and the soft filler 65 come in surface contact with each other as shown in Fig. 5(b), and the thermal conduction paths thus increase. Here, the "surface contact" represents a state where two objects are in contact with each other to form a surface at a contact portion therebetween. For example, the surface contact represents a state where the hard filler 64 and the soft filler 65 are brought in contact with each other to have a contact area in the range of 0.01 $\mu m^2$ to 25 $\mu m^2$, preferably in the range of 0.05 $\mu m^2$ to 10 $\mu m^2$, more preferably in the range of 0.1 $\mu m^2$ to 5 $\mu m^2$.

The thermally conductive resin 60 contains the soft filler 65 having a thin plate shape, preferably a scale shape, a laminar shape, or a flake shape. The soft filler 65 having such a shape can easily be curved along the surface of the hard filler 64 at the contact portion 66, as shown in Fig. 5(b). As a result, the contact area between the soft filler 65 and the hard filler 64 further increases so that the thermal conductivity of the thermally conductive resin 60 can be further improved.

When the soft filler 65 contained in the thermally conductive resin 60 has a thin plate shape, a ratio of the thickness of the soft filler 65 and the largest diameter of the main surface of the soft filler 65 (an aspect ratio) is preferably in the range of 1 to 40. The aspect ratio of the soft filler 65 is more preferably in the range of 3 to 30, particularly preferably in the range of 5 to 20. The soft filler 65 having the aspect ratio within such a range can be easily curved by being pressed by the hard filler 64 so as to increase the contact area between the hard filler 64 and the soft filler 65.

The material included in the hard filler 64 may be any material as long as it has Mohs hardness of 5 or greater. The hard filler 64 may be at least one substance selected from the group consisting of aluminum oxide, magnesium oxide, fused silica, crystalline silica, aluminum nitride, silicon nitride, silicon carbide, and zinc oxide.

The material included in the soft filler 65 may be any material as long as it has Mohs hardness of 3 or less. The soft filler 65 may be at least one substance selected from the group consisting of diatomite, boron nitride, aluminum hydroxide, magnesium hydroxide, magnesium carbonate, calcium carbonate, talc, kaolin, clay, and mica. Among these, boron nitride is preferably used as a material of the soft filler 65. Here, the Mohs hardness represents how easily the material is scratched. The thermally conductive resin 60 is evaluated with the Mohs hardness divided into 10 levels.

The shape of the hard filler 64 is not particularly limited but is preferably a spherical shape or a polyhedron. The particle diameter of each of the hard filler 64 and the soft filler 65 (median diameter: d50) is not particularly limited but is preferably in the range of 5 $\mu m$ to 200 $\mu m$. Here, the median diameter can be measured by use of a laser diffraction particle size analyzer.

The binder resin 63 is not particularly limited and may be thermosetting resin or thermoplastic resin or may be a combination thereof. However, the thermosetting resin is preferable because it can be filled with the hard filler 64 and the soft filler 65 with high density and have an effect of highly increasing thermal conductivity. Although the thermosetting resin used can be conventionally-known one, the thermosetting resin may be at least one resin selected from the group consisting of unsaturated polyester resin, epoxy acrylate resin, and epoxy resin, particularly in view of high moldability and mechanical strength.

The thermally conductive resin 60 preferably contains the thermally conductive filler 62 (the hard filler 64, the soft filler 65) in the binder resin 63 in the range of 40% by volume or greater to less than 95% by volume. The thermally conductive resin 60 containing 40% by volume or greater of the thermally conductive filler 62 can greatly improve the thermal conductivity. In addition, the thermally conductive resin 60 containing less than 95% by volume of the thermally conductive filler 62 can suppress an excessive increase in viscosity when the thermally conductive resin 60 is produced so as to prevent deterioration of moldability.

The content percentage of the thermally conductive filler 62 in the thermally conductive resin 60 may be calculated as follows. First, thermally conductive resin is cured to obtain a molding, and the molding is then cut into test pieces having a predetermined shape so as to calculate the volume thereof by Archimedes' method. Subsequently, the molding is baked at 625 °C in a muffle furnace, and the weight of resultant ash is measured. Since the resultant ash is thermally conductive filler, the volume fraction of the total filler contained in the thermally conductive resin is calculated based on a weight ratio of the respective fillers calculated by the method described below and densities of the fillers. For the calculation of the total volume fraction, the densities of the respective fillers are set to: 3.6 $g/cm^3$ for magnesium oxide; 4.0 $g/cm^3$ for aluminum oxide; 2.4 $g/cm^3$ for aluminum hydroxide; and 2.2 $g/cm^3$ for boron nitride.

The volume ratio between the hard filler 64 and the soft filler 65 contained in the thermally conductive resin 60 is preferably in the range of 95:5 to 50:50 as shown in the following formula (1).

$$\text{Hard filler/soft filler} = 95/5 \text{ to } 50/50 \quad \dots (1)$$

When the volume ratio between the hard filler 64 and the soft filler 65 is included in the range described above, the soft filler 65 can be deformed sufficiently by the hard filler 64 so that the thermally conductive resin 60 can ensure high thermal conductivity.

The volume ratio between the hard filler 64 and the soft filler 65 may be obtained as follows. First, a 1-millimeter square analysis area in the cured thermally conductive resin (molding) is irradiated with X-rays by use of an X-ray photoelectron spectrometer. The analysis in the depth direction is carried out in a manner such that a sample surface is cut by sputtering with argon ion irradiation, and a deep portion is then analyzed so as to calculate an element concentration (atm.%) derived from inorganic filler contained in the molding at a predetermined depth. Based on a ratio of the element concentrations derived from the hard filler 64 and the soft filler 65 calculated by X-ray photoelectron spectroscopy and densities of the respective inorganic fillers, the weight ratio and the volume ratio between the hard filler and the soft filler contained in the thermally conductive resin are calculated. Here, the above-described densities of the fillers are used for the calculation of the volume ratio.

Next, a method for producing the thermally conductive resin 60 as described above using thermosetting resin as the binder resin 63 is explained below. First, the respective raw materials necessary for producing the thermally conductive resin, namely, the filler and the thermosetting resin, are combined in a predetermined ratio. These materials are then mixed with a mixer or a blender and kneaded with a kneader or a roller so as to obtain a thermosetting resin compound before cured. A required amount of the compound thus obtained is poured into a metal mold and then heated and pressurized so as to obtain the unit body 10 of the base unit 1 according to the present embodiment. Here, the respective conditions such as a molding temperature and a molding pressure may be determined as appropriate depending on a shape of a molding desired.

In the thermally conductive resin 60, the hard filler 64 and the soft filler 65 come in surface contact with each other in the binder resin 63 to form thermal conduction paths. As a result, the thermally conductive resin 60 has higher thermal conductivity than the case where the hard filler or the soft filler is contained alone in the resin. In addition, the inclusion of the soft filler can improve the fluidity and moldability of the resin. The improvement of fluidity of the resin can decrease mold abrasion at the time of molding and reduce frequency of mold exchange. Accordingly, an increase in thermal conduction and moldability can be achieved without increase in content of the thermally conductive filler.

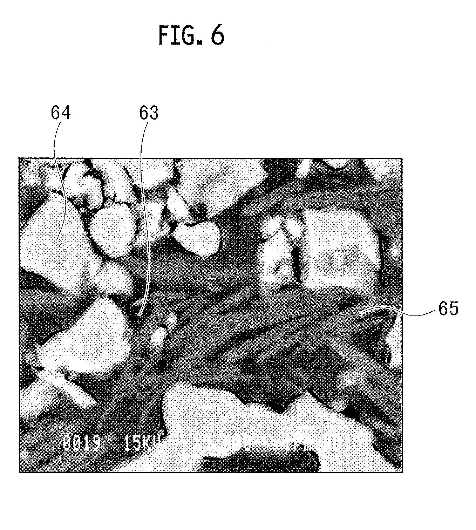

Fig. 6 is a scanning electron microphotograph of the thermally conductive resin using epoxy acrylate resin for the binder resin 63, magnesium oxide for the hard filler 64, and boron nitride for the soft filler 65. The Mohs hardness of magnesium oxide is 6, and the Mohs hardness of boron nitride is 2. As shown in Fig. 6, the soft filler 65 is pressed and curved by the hard filler 64 so as to increase the contact area between the hard filler 64 and the soft filler 65. As a result, the thermal conduction paths increase so that the thermally conductive resin having high thermal conductivity can be obtained.

As described above, the thermally conductive resin included in the unit body 10 preferably contains the thermally conductive filler and the binder resin. The thermally conductive filler preferably contains the hard filler having Mohs hardness of 5 or greater and the soft filler having Mohs hardness of 3 or less and having a scale shape, a laminar shape, a flake shape, or a plate shape. Further, the hard filler is preferably at least one substance selected from the group consisting of aluminum oxide, magnesium oxide, fused silica, crystalline silica, aluminum nitride, silicon nitride, silicon carbide, and zinc oxide, and the soft filler is preferably boron nitride.

The hard filler is more preferably magnesium oxide. The binder resin preferably contains either unsaturated polyester resin or epoxy acrylate resin or both of them.

The content of the hard filler and the soft filler mixed together is preferably in the range of 50% by volume or greater to less than 95% by volume with respect to the total content of the thermally conductive resin. The volume ratio between the hard filler and the soft filler in the thermally conductive resin is preferably in the range shown in the following formula (1).

$$\text{Hard filler/soft filler} = 95/5 \text{ to } 50/50 \dots (1)$$

The molding (the unit body) obtained by molding the thermally conductive resin preferably has a configuration in which the soft filler is curved, and the hard filler and the soft filler come in surface contact with each other in the thermally conductive resin.

<Method for manufacturing base unit>

The method for manufacturing the base unit 1 is not particularly limited and may be a common method for molding thermally conductive resin, such as compression molding, transfer molding, and injection molding. In particular, the metal member 11 is preliminarily fixed to a mold, the mold is filled with the thermally conductive resin, and the thermally conductive resin is solidified together with the metal member 11 so as to obtain the base unit 1.

<Operation of base unit>

In the LED unit 100 according to the present embodiment, the base unit 1 is formed of a molding in which a metal member 11 is covered with the thermally conductive resin. In other words, the base unit 1 used in the present embodiment is a resin/metal-composite heat sink including the thermally conductive resin and the metal member. Thus, the heat generated in the light emitting device 3 can be radiated efficiently through the base unit 1 toward the light fixture to which the LED unit 100 is fixed. Since the metal member 11 is covered with the thermally conductive resin, the thermally conductive resin is interposed between the light emitting device 3 and the metal member 11. Accordingly, the electrical insulation property therebetween can be ensured without use of a conventional electrical insulating sheet.

Further, the unit body 10 of the base unit 1 is formed of the thermally conductive resin. Therefore, the moldability can be greatly improved so as to facilitate the formation of a complicated shape.

In the LED unit 100 of the present embodiment, the metal member 11 is exposed on the rear surface 1s of the base unit 1. The heat generated in the light emitting device 3 is thus easily transmitted to the light fixture in contact with the rear surface 11 a. Accordingly, a decrease in light emitting efficiency of the light emitting device 3 can reliably be suppressed.

The thermal conductivity of the metal member 11 in the LED unit 100 is preferably in the range of 50 to 400 W/m·K. The metal member having the thermal conductivity in such a range can enhance the heat radiation performance of the base unit 1 and improve the light emitting efficiency of the light emitting device.

EXAMPLE

The present embodiment is explained in more detail below with reference to an example; however, the present embodiment is not limited to the example.

<Manufacture of base unit>

A compound as a raw material of the unit body in the base unit was prepared as follows. For the preparation of the compound, the following thermosetting resin, thermoplastic resin, diluent, polymerization inhibitor, viscosity adjuster, curing catalyst, mold release agent, inorganic filler, flame retardant and glass fiber were used. The mixture amounts of these materials in the compound are shown in Table 1.

(Thermosetting resin)

Epoxy acrylate resin (manufactured by Japan U-PICA Company Ltd. "NEOPOL (registered trademark) 8250H")
Unsaturated polyester resin (manufactured by Showa Highpolymer Co., Ltd. "M-640LS")

(Thermoplastic resin)

Polystyrene resin (manufactured by NOF Corporation "MODIPER (registered trademark) SV10B")

(Diluent)

Styrene

(Polymerization inhibitor)

p-benzoquinone

(Viscosity adjuster)

Manufactured by BYK-Chemie Japan K. K.: "BYK-W9010"

(Curing catalyst)

t-amylperoxy isopropyl carbonate

(Mold release agent)

Zinc stearate, stearic acid

(Inorganic filler)

Magnesium oxide (median diameter: 50 $\mu$m, spherical shape, specific surface area: 0.4 m$^2$/g)
Magnesium oxide (median diameter: 5 $\mu$m, spherical shape, specific surface area: 2.2 m$^2$/g)
Boron nitride (median diameter: 8.5 $\mu$m, plate shape, specific surface area: 4.0 m$^2$/g)
Here, the magnesium oxides are produced by dead-burning.

(Flame retardant)

Brominated epoxy, diantimony trioxide ($Sb_2O_3$)

(Glass fiber)

Chopped strands for BMC molding material reinforcement (manufactured by Nitto Boseki Co., Ltd. "CS3E-227")

[Table 1]

| | | Mixture Amount (parts by mass) |
|---|---|---|
| Thermosetting Resin | unsatulated polyester | 140 |
| | epoxy acrylate resin | 396 |
| Thermoplastic Resin | polyethylene | 49 |
| Diluent | styrene | 114 |
| Polymerization Inhibitor | p-benzoquinone | 0.24 |
| Viscosity Adjuster | BYK-W9010 | 5.04 |
| Curing Catalyst | t-amylperoxy isopropyl carbonate | 13 |
| Mold Release Agent | zinc stearate | 20 |
| | stearic acid | 59 |
| Inorganic Filler | MgO (50 $\mu$m) | 1597 |
| | MgO (5 $\mu$m) | 1078 |
| | BN | 860 |
| Flame Retardant | brominated epoxy | 159 |
| | $Sb_2O_3$ | 159 |
| Glass fiber | chopped strands for BMC molding material reinforcement | 353 |

First, the above-mentioned thermosetting resin, thermoplastic resin, diluent, polymerization inhibitor, viscosity adjuster, curing catalyst and mold release agent were mixed in the mixture amounts shown in Table 1. Subsequently, the mixture of these materials was stirred by use of a pressure kneader (manufactured by Toshin Co., Ltd.: "TD3-10MDX") with a pressure hood open so as to prepare a resin solution. Here, the thermosetting resin was preliminarily dissolved in the diluent, and the thermosetting resin in the state of solution was mixed with other materials.
The resin solution thus obtained was then added with the inorganic filler and the flame retardant in the mixture amounts shown in Table 1 and kneaded at 50 to 60 °C for 20 minutes. The glass fiber was further added therein in the mixture amount shown in Table 1 and kneaded at 20 °C for 5 minutes. As a result, the compound was prepared as a raw material of the unit body.

The base unit of this example was prepared as follows by use of the compound thus obtained. First, the metal member 11 having a thickness of 6 mm was fixed to a mold in a low-pressure sealing transfer molding machine (manufactured by SHINTO Metal Industries Corporation "ETA-30D"). The mold was then heated to 165 °C and filled with the compound. The thermosetting resin contained in the compound was thus melted and softened by heating and deformed into a predetermined shape and then cured so as to manufacture the base unit in which the metal member was placed in the thermally conductive resin. The thickness of the resin layer 10b in the base unit in this example was 0.6 mm.

<Evaluation of base unit>

A breakdown voltage between the front surface and the rear surface of the base unit manufactured as described above was measured by the following method in accordance with Japanese Industrial Standards JIS C2110-1.

A testing apparatus used was a breakdown voltage tester (manufactured by Yamayo Tester Co., Ltd. "YST-243-100RHO"). A spherical electrode with ϕ 12.5 mm was fixed to the front end surface 1fa of the resin layer 10b of the base unit, and a cylindrical electrode with ϕ 25 mm was fixed to the rear surface 11a of the metal member 11. The base unit to which the spherical electrode and the cylindrical electrode were fixed was placed in silicone oil at 23 °C.

The breakdown voltage was measured at five points on the front end surface 1fa of the protruding base portion 1f of the base unit, and an average value thereof was determined as a breakdown voltage of the base unit. The evaluation revealed that the breakdown voltage of the base unit of this example resulted in 15.1 kV/mm so that a sufficient insulation property was ensured.

[Second embodiment]

An LED unit according to a second embodiment is explained in detail below with reference to the drawings. Note that the same elements as those in the first embodiment are indicated by the same reference numerals, and overlapping explanations thereof are not repeated below.

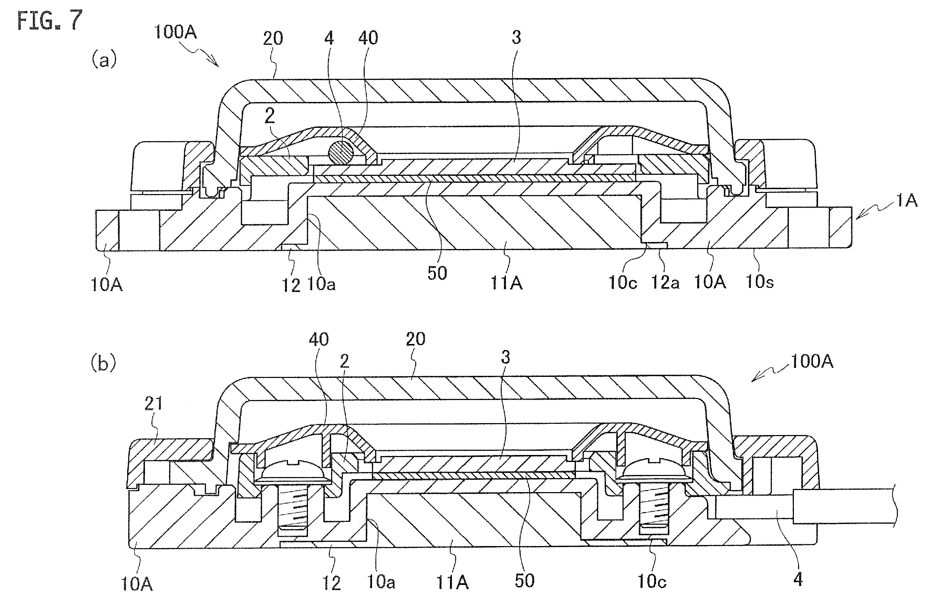

An LED unit 100A according to the second embodiment includes a base unit 1A having a disk-like shape, and the light emitting device 3 placed on the front surface of the base unit 1A, as in the case of the first embodiment. The LED unit 100A further includes the holder 2, the cover 20, the cover holding member 21, and the inner cover 40, as shown in Fig. 7.

As described above, the base unit 1 according to the first embodiment includes the protruding base portion 1f formed substantially into a rectangular parallelepiped to which the light emitting device 3 is fixed. Thus, the metal member 11 is also formed substantially into a rectangular parallelepiped conforming to the protruding base portion 1f. However, the shape of the metal member is not limited thereto and may be any shape as long as it can ensure the thermal conductivity of the base unit.

As shown in Fig. 7, a metal member 11A according to the present embodiment is provided with a flat flange 12 in at least part of the circumference of the rear surface 11a of the metal member 11 according to the first embodiment so as to increase the area of the rear surface 11a. A unit body 10A is provided with a recess 10c conforming to the flange 12, in addition to the concavity 10a. Since the metal member 11A has the flange 12, and a rear surface 12a of the flange 12 is brought into contact with a light fixture to which the LED unit 100 is fixed, the contact area between the light fixture and the metal member 11A increases. As a result, heat can be radiated from the light emitting device 3 toward the light fixture more efficiently. In order to further improve the heat radiation performance, the flange 12 is preferably provided in the entire circumference of the rear surface 11a of the metal member 11 according to the first embodiment.

[Third embodiment]

An LED unit according to a third embodiment is explained in detail below with reference to the drawings. Note that the same elements as those in the first embodiment are indicated by the same reference numerals, and overlapping explanations thereof are not repeated below.

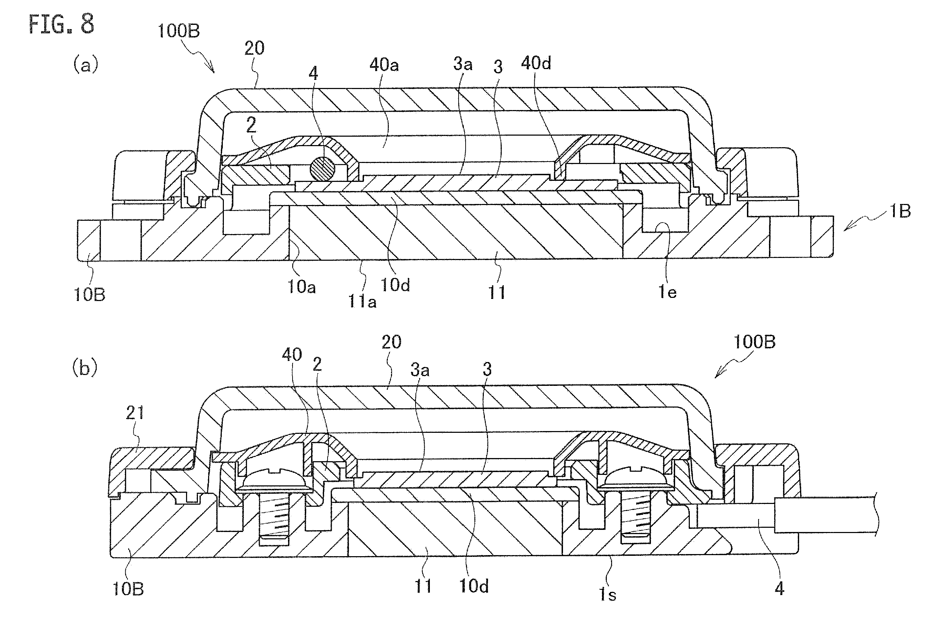

An LED unit 100B according to the third embodiment includes a base unit 1B having a disk-like shape, and the light emitting device 3 placed on the front surface of the base unit 1B, as in the case of the first and second embodiments. The LED unit 100B further includes the holder 2, the cover 20, the cover holding member 21, and the inner cover 40, as shown in Fig. 8.

The base unit 1B is provided with the circular recessed portion 1e on the front surface thereof, and the protruding base portion 1f is provided in the middle of the inner bottom surface of the recessed portion 1e, as in the case of the first embodiment. The package substrate 3b of the light emitting device 3 is placed on the front end surface 1fa of the protruding base portion 1f of the base unit. The metal member 11 is placed inside the protruding base portion 1f of the base unit, and the rear surface 11 a of the metal member 11 is exposed on the rear surface 1s of the base unit.

In the first embodiment, the thermal interface material (TIM) 50 is applied between the package substrate 3b and the protruding base portion 1f in order to improve the thermal conductivity between the light emitting device 3 and the base unit 1. Here, it would be possible to further increase the conductivity of heat from the light emitting device 3 toward the base unit 1 if the package substrate 3b and the protruding base portion If could be brought into contact with each other without use of the TIM 50. However, the package substrate 3b and the protruding base portion 1f in direct contact with each other cannot be deformed when both having high hardness, which may produce an air layer between the front end surface 1fa of the protruding base portion 1f and the other surface of the package substrate 3b. The air layer present therebetween prevents heat from being transmitted from the package substrate 3b to the protruding base portion If so that the performance of heat radiation from the light emitting portion 3a may not sufficiently be ensured.

Thus, the LED unit 100B according to the present embodiment includes a flexible low-hardness resin layer 10d formed of thermally conductive resin interposed between the package substrate 3b of the light emitting device 3 and the metal member 11, as shown in Fig. 8. The package substrate 3b of the light emitting device 3 is brought in direct contact with the front end surface 1fa of the protruding base portion 1f formed of the low-hardness resin layer 10d. Therefore, an air layer is not easily formed between the front end surface 1fa and the package substrate 3b because the low-hardness resin layer 10d can be deformed when the package substrate 3b is pressed even through the package substrate 3b of the light emitting device 3 is brought in direct contact with the front end surface 1fa of the protruding base portion 1f. Accordingly, the contact area between the front end surface 1fa and the package substrate 3b increases so as to ensure high thermal conductivity without use of the TIM.

In a unit body 10B of the base unit 1B according to the present embodiment, a Shore A hardness of the thermally conductive resin interposed between the light emitting device 3 and the metal member 11 is preferably in the range of 10 or greater to less than 70, more preferably in the range of 15 or greater to less than 50. The Shore A hardness within such a range can provide flexibility to the low-hardness resin layer 10d formed of the thermally conductive resin and prevent an air layer from being interposed. The Shore A hardness may be measured in accordance with Japanese Industrial Standards JIS K6253-1 (Rubber, vulcanized or thermoplastic-Determination of hardness-Part 1: General guidance).

Examples of the thermally conductive resin included in the low-hardness resin layer 10d include resin showing crystallinity or liquid crystallinity and composite resin obtained in a manner such that thermoplastic resin or thermosetting resin is filled with inorganic filler having high thermal conductivity. In particular, the thermally conductive resin preferably contains highly thermally conductive filler and particularly preferably the same resin as that shown in Fig. 5. In order to ensure flexibility, the binder resin 63 used is preferably common silicone rubber, a styrene-based elastomer, or a polyolefin-based elastomer. Other preferable examples of the binder resin 63 include a polyurethane-based elastomer, a polyamide-based elastomer, an acrylic elastomer, and polyester-based elastomer. These resins may be used alone or in combination of two or more thereof.

According to the present embodiment, the base unit 1B includes the thermally conductive resin covering the metal member 11 and at least interposed between the light emitting device 3 and the metal member 11, the thermally conductive resin having flexibility and the Shore A hardness in the range of 10 or greater to less than 70. The use of such thermally conductive resin can prevent an air layer from being generated even when the light emitting device 3 and the base unit 1B are brought in direct contact with each other so as to further improve the thermal conductivity from the light emitting device 3 toward the metal member 11. In addition, the manufacturing process of the LED unit can be simplified since the step of applying the TIM is not required.

[Fourth embodiment]

An LED unit according to a fourth embodiment is explained in detail below with reference to the drawings. Note that the same elements as those in the first to third embodiments are indicated by the same reference numerals, and overlapping explanations thereof are not repeated below.

<Configuration of LED unit>

An LED unit 100C according to the present embodiment includes, as in the case of the first embodiment, the light emitting device 3 including the package substrate 3b and the light emitting portion 3a provided on the package substrate 3b and having LED chips. The LED unit 100C further includes a heat radiator 70 on which the light emitting device 3 is placed so as to radiate heat from the light emitting device 3. The heat radiator 70 includes a base unit 1C serving as a heat radiating body for radiating heat from the light emitting device 3, and an insulation and heat radiation moulding 80 attached to the base unit 1C to ensure electrical insulation between the light emitting device 3 and the base unit 1C. According to the present embodiment, the light emitting device 3 is placed on the front surface of the base unit 1C with the insulation and heat radiation moulding 80 interposed therebetween.

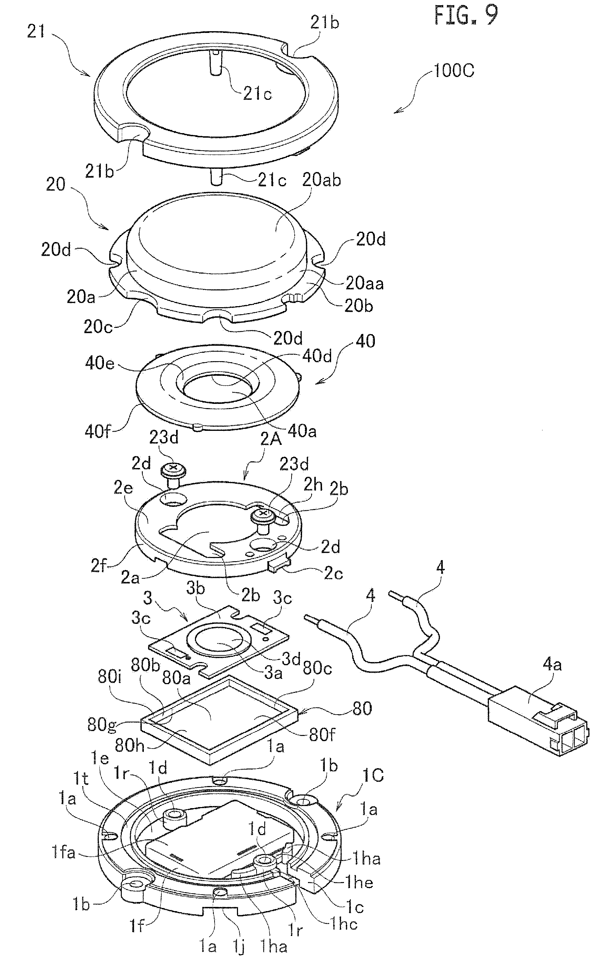

As shown in Fig. 9, the LED unit 100C according to the present embodiment includes the base unit 1C having a disk-like shape, and the light emitting device 3 placed on the front surface of the base unit 1C with the insulation and heat radiation moulding 80 interposed therebetween. The light emitting device 3 is provided, on one surface of the package substrate 3b, with the light emitting portion 3a having LED chips and the terminal portions 3c for supplying power to the light emitting portion 3a. The other surface of the package substrate 3b is placed to face the base unit 1C with the insulation and heat radiation moulding 80 interposed therebetween.

The LED unit 100C includes a holder 2A placed on the light emitting device 3 on the opposite side of the base unit 1C (the heat radiator 70) with the package substrate 3b held between the holder 2A and the base unit 1C (the heat radiator 70). The LED unit 100C further includes the cover 20 and the cover holding member 21 placed on the holder 2A on the opposite side of the base unit 1C and fixed to the base unit 1C.

The base unit 1C includes the protruding base portion 1f provided in the middle of the inner bottom surface of the recessed portion 1e, as in the case of the first embodiment. The front end surface 1fa of the protruding base portion 1f faces the other surface of the package substrate 3b with the insulation and heat radiation moulding 80 interposed therebetween.

In order to improve the thermal conductivity between the light emitting device 3 and the insulation and heat radiation moulding 80, the thermal interface material (TIM) may be applied between the package substrate 3b and the insulation and heat radiation moulding 80, as in the case of the first embodiment.

The holder 2A includes the upper wall portion 2e as in the case of the first embodiment. The upper wall portion 2e is provided with holding plate portions 2h for holding the package substrate 3b of the light emitting device 3 between the upper wall portion 2e and the insulation and heat radiation moulding 80. The holding plate portions 2h project from the upper wall portion 2e toward the package substrate 3b. The holder 2A further includes the circumferential wall portion 2f extending from the circumference of the upper wall portion 2e toward the base unit 1C.

<Configuration of heat radiator>

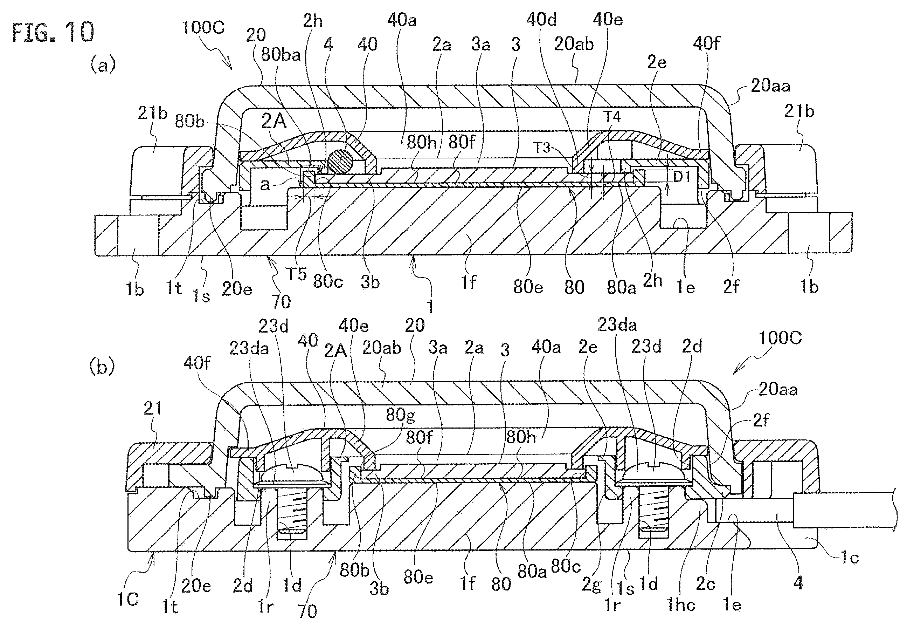

The heat radiator 70 used in the LED unit 100C according to the present embodiment includes the base unit 1C and the insulation and heat radiation moulding 80 formed of thermally conductive resin, as shown in Fig. 10.

As described above, the base unit 1C includes the circular recessed portion 1e on the front surface thereof and the protruding base portion 1f in the middle of the bottom surface of the recessed portion 1e. The insulation and heat radiation moulding 80 on which the package substrate 3b of the light emitting device 3 is placed is formed on the front end surface 1fa of the protruding base portion 1f. The protruding base portion If of the base unit 1C is formed substantially into a rectangular parallelepiped as shown in Fig. 9.

The insulation and heat radiation moulding 80 is formed from the thermally conductive resin. Therefore, the electrical insulation property between the light emitting device 3 and the base unit 1C can be ensured without use of a conventional thermally conductive sheet having an electrical insulation property. The thermally conductive resin that can be used for the insulation and heat radiation moulding 80 preferably has thermal conductivity of 1.5 W/m·K or greater. The use of such resin can enhance the performance of heat radiation from the light emitting device 3 toward the base unit 1 C and improve the light emitting efficiency of the light emitting device 3. The upper limit of the thermal conductivity of the thermally conductive resin is not particularly limited but may be set to 10 W/m·K. As described above, resin having high thermal conductivity does not have a problem with heat radiation performance, but moldability thereof may deteriorate because of insufficient resin fluidity. For this reason, the thermal conductivity of the thermally conductive resin included in the insulation and heat radiation moulding 80 is preferably set in the range of 1.5 to 10 W/m·K. The thermally conductive resin used is preferably the resin described in the first embodiment.

According to the present embodiment, the insulation and heat radiation moulding 80 is provided with a concavity 80c in which the light emitting device 3 is placed.

As shown in Fig. 9 and Fig. 10, the insulation and heat radiation moulding 80 includes a bottom wall portion 80a having a rear surface (one surface) 80e attached to the base unit 1C and a front surface (the other surface) 80f on which the package substrate 3b of the light emitting device 3 is placed. The insulation and heat radiation moulding 80 further includes a side wall portion 80b provided along the circumference of the bottom wall portion 80a. The insulation and heat radiation moulding 80 is thus provided with the concavity 80c defined by the bottom wall portion 80a and the side wall portion 80b.

The bottom wall portion 80a is formed substantially into a rectangular plate shape in the plan view slightly smaller than the front end surface 1fa of the protruding base portion 1f. The rear surface (one surface) 80e of the bottom wall portion 80a is attached to the front end surface 1fa of the protruding base portion 1f in the base unit 1C. The bottom wall portion 80a and the protruding base portion 1f may be formed in a manner such that the bottom wall portion 80a has substantially the same size as the front end surface 1fa of the protruding base portion 1f. Alternatively, the bottom wall portion 80a and the protruding base portion 1f may be formed in a manner such that the bottom wall portion 80a is slightly larger than the front end surface 1fa of the protruding base portion 1f.

The side wall portion 80b is formed to extend upward from the circumference of the bottom wall portion 80a. The side wall portion 80b extends upward on the opposite side of the base unit 1C. According to the present embodiment, the side wall portion 80b is formed in the entire circumference of the bottom wall portion 80a.

According to the present embodiment, the insulation and heat radiation moulding 80 is formed into a rectangular box shape having the concavity 80c provided with an opening 80g on the upper side thereof. The package substrate 3b is inserted into the concavity 80c from the opening 80g, and the rear surface of the package substrate 3b is brought in surface contact with a rectangular bottom surface 80h of the concavity 80c so that the package substrate 3b is positioned in the concavity 80c. Note that the side wall portion 80b is not necessarily formed in the entire circumference of the bottom wall portion 80a.

According to the present embodiment, the rectangular bottom surface 80h of the concavity 80c has substantially the same size as the rear surface of the package substrate 3b in the plan view. Since the rectangular bottom surface 80h has substantially the same size as the rectangular package substrate 3b in the plan view, the package substrate 3b is positioned by the side wall portion 80b.

According to the present embodiment, as shown in Fig. 10, depth D1 of the concavity 80c is greater than thickness T3 of the package substrate 3b. That is, an upper end portion 80i of the side wall portion 80b projects upward by the difference (D1-T3) from the surface of the package substrate 3b when the package substrate 3b is placed in the concavity 80c. The upper end portion 80i of the side wall portion 80b projecting upward from the surface of the package substrate 3b can increase a distance along surfaces between the package substrate 3b and the base unit 1C as indicated by arrow a in Fig. 10(a). In other words, the distance along the surfaces between the package substrate 3b and the base unit 1C can be increased without the insulation and heat radiation moulding 80 widened in the direction parallel to the surface of the bottom wall portion 80a. Note that an excessive increase in the depth D1 of the concavity 80c leads to an excessive increase in height of the side wall portion 80b to increase the size in the height direction. Thus, the height of the upper end surface of the side wall portion 80b is preferably substantially the same as or less than the height of the light emitting portion 3a. The present embodiment exemplifies the case where the insulation and heat radiation moulding 80 is formed in a manner such that the height of the upper end surface of the side wall portion 80b is slightly less than the height of the light emitting portion 3 a.

When the height of the upper end surface of the side wall portion 80b is substantially the same as or less than the height of the light emitting portion 3a, light emitted from the light emitting portion 3a can be prevented from being blocked with the side wall portion 80b. Further, an increase in size in the height direction can also be prevented.

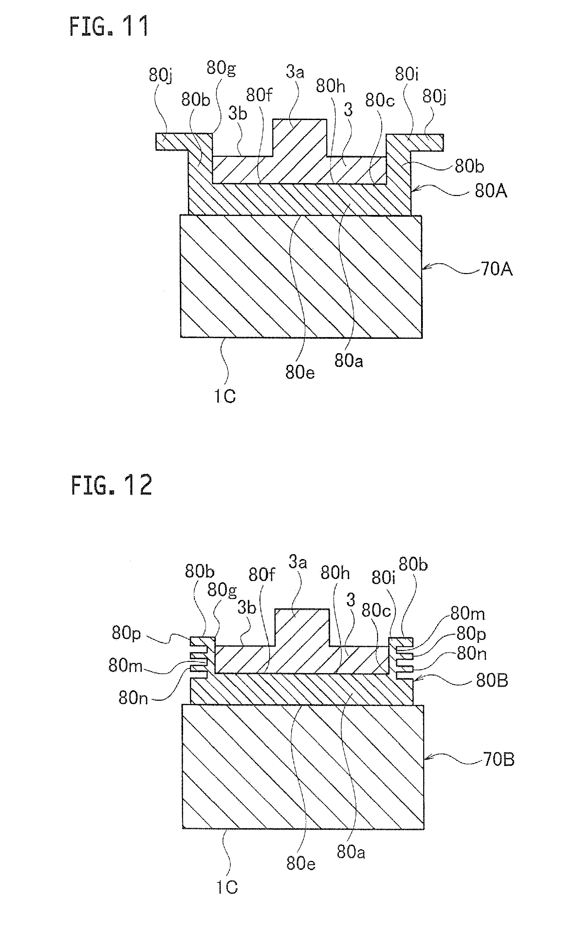

However, when the height of the upper end surface of the side wall portion 80b is substantially the same as or less than the height of the light emitting portion 3a, it is difficult to ensure a sufficient distance along the surfaces between the package substrate 3b and the base unit 1C. If thickness T5 of the side wall portion 80b in the width direction increases, the size in the diameter direction increases although the distance along the surfaces between the package substrate 3b and the base unit 1C can be increased. Thus, when the height of the upper end surface of the side wall portion 80b is substantially the same as or less than the height of the light emitting portion 3a, the configuration shown in Fig. 11 or Fig. 12 is preferably employed so as to ensure the sufficient distance along the surfaces between the package substrate 3b and the base unit 1C.

The height of the upper end surface of the side wall portion 80b may be greater than the height of the light emitting portion 3a, although the size in the height direction is increased. When the height of the upper end surface of the side wall portion 80b is greater than the height of the light emitting portion 3a, the sufficient distance along the surfaces between the package substrate 3b and the base unit 1C can be ensured while an increase in size in the diameter direction is prevented. Here, if the side wall portion 80b protrudes upward (in the direction where light is emitted) from the light emitting portion 3 a, light emitted from the light emitting portion 3a may be blocked with the side wall portion 80b. However, the present embodiment can prevent such a problem in a manner such that the inner cover 40 is interposed between the light emitting portion 3a and the side wall portion 80b so that the light emitting portion 3a is surrounded with the inner cover 40.

In the present embodiment, the insulation and heat radiation moulding 80 is integrally formed with no joint. Namely, the insulation and heat radiation moulding 80 is not provided with joints which are formed in a case where plural split parts are fixed together with an adhesive or the like. The insulation and heat radiation moulding 80 as an integrated article may be formed by a common method for molding thermally conductive resin. In particular, a metal mold is filled with the thermally conductive resin, and the resin is then solidified so as to obtain the insulation and heat radiation moulding 80 as an integrated article. Although the insulation and heat radiation moulding 80 is preferably integrally formed with no joint, at least the bottom wall portion 80a that is placed on the base unit 1C is only required to be integrally formed with no joint. Thus, the side wall portion 80b is not necessarily integrally formed without joint.

The base unit 1C may be any of the base units 1, 1A and 1B according to the first to third embodiments. As described above, since the base units 1, 1A and 1B have both high thermal conduction and electrical insulation properties, the respective base units can ensure a higher electrical insulation property when the insulation and heat radiation moulding 80 is combined together. However, since the insulation and heat radiation moulding 80 itself has a high electrical insulation property, the base unit 1C may be formed of a material having high thermal conductivity such as metal or ceramics.

When the base unit 1C is formed of metal, the metal contained is not limited as long as it can sufficiently radiate heat generated in the light emitting device 3. For example, the metal included in the base unit 1C may be the metal included in the metal member 11 as explained in the first embodiment.

As described above, the insulation and heat radiation moulding 80 formed of the thermally conductive resin is formed on the front end surface 1fa of the protruding base portion 1f of the base unit 1C. The package substrate 3b of the light emitting device 3 is further placed on the insulation and heat radiation moulding 80. Therefore, the insulation and heat radiation moulding 80 formed of the thermally conductive resin is interposed between the package substrate 3b of the light emitting device 3 and the base unit 1C. Accordingly, the electrical insulation property between the light emitting device 3 and the base unit 1C can be ensured with the insulation and heat radiation moulding 80 interposed therebetween.

Thickness T4 of the bottom wall portion 80a of the insulation and heat radiation moulding 80 in the stacked direction of the base unit 1C and the light emitting device 3 is not particularly limited as long as the electrical insulation property can be ensured, but is preferably in the range of 0.3 mm or greater to 1 mm or less. The thickness T4 in such a range can prevent a decrease in thermal conductivity while exerting the electrical insulation performance on the light emitting device 3. In the insulation and heat radiation moulding 80 according to the present embodiment, the thickness of the bottom wall portion 80a is set to 0.5 mm.

According to the present embodiment, the thickness T5 of the side wall portion 80b in the width direction is greater than the thickness T4 of the bottom wall portion 80a in the height direction. This configuration can prevent a decrease in strength of the insulation and heat radiation moulding 80 while reducing the thickness of the bottom wall portion 80a. The thickness T5 of the side wall portion 80b is not necessarily greater than the thickness T4 of the bottom wall portion 80a. The thickness T5 of the side wall portion 80b may be less than the thickness T4 of the bottom wall portion 80a or equal to the thickness T4 of the bottom wall portion 80a.

In the present embodiment, the breakdown voltage of the insulation and heat radiation moulding 80 is preferably 5 kV/mm or greater. The breakdown voltage of 5 kV/mm or greater can prevent a short circuit between the light emitting device 3 and the base unit 1C and prevent a malfunction or abnormal heat generation of the light emitting device 3. The upper limit of the breakdown voltage of the insulation and heat radiation moulding 80 is not particularly limited but may be set to 40 kV/mm. The breakdown voltage of the insulation and heat radiation moulding 80 may be measured in accordance with Japanese Industrial Standards JIS C2800-1.

<Thermally conductive resin>

As described above, the insulation and heat radiation moulding 80 in the LED unit 100C according to the present embodiment is formed of the thermally conductive resin having an electrical insulation property. The thermally conductive resin used preferably not only has the thermal conduction and electrical insulation properties but also exhibits high moldability. The thermally conductive resin having such characteristics may be the same resin used in the unit body 10 in the first embodiment.

The insulation and heat radiation moulding 80 having flexibility is preferably formed of silicone resin or elastomer resin. When the insulation and heat radiation moulding 80 is formed of the resin having flexibility, the package substrate 3b can adhere to the insulation and heat radiation moulding 80 more reliably when the package substrate 3b is placed on the insulation and heat radiation moulding 80. Thus, the adhesion between the package substrate 3b and the insulation and heat radiation moulding 80 can be improved without the thermal interface material (TIM) applied therebetween. Accordingly, the step of applying the thermal interface material between the package substrate 3b and the insulation and heat radiation moulding 80 can be omitted so as to facilitate the manufacturing process and simplify the configuration. In addition, manufacturing costs can be reduced since the thermal interface material is not used.

<Method for manufacturing heat radiator>

The method for manufacturing the heat radiator 70 is not particularly limited and may be a common method for molding thermally conductive resin, such as pressure molding, transfer molding, and injection molding. In particular, the base unit 1C is preliminarily fixed to a mold, the mold is filled with the thermally conductive resin, and the thermally conductive resin is solidified together with the base unit 1C so as to obtain the heat radiator 70. Alternatively, the heat radiator 70 may be obtained in a manner such that the insulation and heat radiation moulding 80 preliminarily molded into a preferred shape is fixed to the base unit 1C with an adhesive or the like.

<Operation of heat radiator>

The heat radiator 70 used in the LED unit 100C according to the present embodiment includes the base unit 1C for radiating heat generated in the light emitting device 3 including the package substrate 3b and the light emitting portion 3a provided on the package substrate 3b. The heat radiator 70 further includes the insulation and heat radiation moulding 80 attached to the base unit 1C so as to ensure electrical insulation between the light emitting device 3 and the base unit 1C. Thus, the heat radiator 70 includes the base unit 1C and the insulation and heat radiation moulding 80 formed of the thermally conductive resin. Therefore, the heat generated in the light emitting device 3 can be efficiently radiated through the base unit 1C toward a light fixture to which the LED unit 100C is attached. Further, since the insulation and heat radiation moulding 80 is formed of the thermally conductive resin, the thermally conductive resin is interposed between the light emitting device 3 and the base unit 1C. Thus, the electrical insulation property therebetween can be ensured without use of a conventional thermally conductive sheet having an electrical insulation property. Accordingly, the step of applying a thermally conductive sheet is not required so as to simplify the manufacturing process. Further, a possibility of poor performance of applying a thermally conductive sheet can be prevented so as to increase reliability of products.

In the present embodiment, the insulation and heat radiation moulding 80, which provides electrical insulation between the light emitting device 3 and the base unit 1C, can be formed by a common method for molding thermally conductive resin. Thus, the performance of molding the insulation and heat radiation moulding 80 is greatly improved so as to facilitate the formation of a complicated shape. The use of the insulation and heat radiation moulding 80 can reduce the thickness of the resin (the thickness T4 of the bottom wall portion 80a in the height direction) interposed between the light emitting device 3 and the base unit 1C compared with the conventional case where an electrical insulating sheet is used. Further, the improvement in moldability of the insulation and heat radiation moulding 80 does not require the base unit 1C to be processed into a complicated shape so as to reduce manufacturing costs.

The insulation and heat radiation moulding 80 is provided with the concavity 80c in which the light emitting device 3 is placed. The configuration of the insulation and heat radiation moulding 80 provided with the concavity 80c in which the light emitting device 3 is placed can increase the distance along the surfaces between the package substrate 3b and the base unit 1C while preventing an increase in size of the insulation and heat radiation moulding 80. Accordingly, a reduction in size of the heat radiator 70 can be achieved.

The insulation and heat radiation moulding 80 includes the bottom wall portion 80a having the rear surface (one surface) 80e attached to the base unit 1C and the front surface (the other surface) 80f on which the package substrate 3b of the light emitting device 3 is placed. The insulation and heat radiation moulding 80 further includes the side wall portion 80b projecting from the bottom wall portion 80a. Further, the rectangular bottom surface 80h of the concavity 80c has substantially the same size as the rear surface of the rectangular package substrate 3b in the plan view so that the package substrate 3b is positioned by the side wall portion 80b. The package substrate 3b can be positioned only in such a manner as to be placed in the concavity 80c so as to facilitate the positioning of the package substrate 3b. Accordingly, the manufacture of the LED unit 100C can be further facilitated, and the reliability of products can be further enhanced. Although the present embodiment exemplifies the case where the entire circumference of the package substrate 3b is positioned by the side wall portion 80b, part of the package substrate 3b, for example, adjacent two sides or opposed two sides, may be positioned by the side wall portion 80b.

According to the present embodiment, the depth D1 of the concavity 80c is greater than the thickness T3 of the package substrate 3b. That is, the upper end portion 80i of the side wall portion 80b projects upward by the difference (D1-T3) from the surface of the package substrate 3b when the package substrate 3b is placed in the concavity 80c. Thus, the distance along the surfaces between the package substrate 3b and the base unit 1C can be increased without the insulation and heat radiation moulding 80 widened in the direction parallel to the surface of the bottom wall portion 80a. In addition, the distance along the surfaces between the package substrate 3b and the base unit 1C can be increased while the thickness T5 of the side wall portion 80b in the width direction is reduced so as to further decrease the size of the heat radiator 70. Since the upper end portion 80i of the side wall portion 80b projects upward from the surface of the package substrate 3b, a short circuit between the light emitting device 3 and the base unit 1C is not caused over the upper end portion 80i. For example, even if a discharge is caused at the contact portion between the electric wire 4 and the terminal portion 3c formed in the package substrate 3b, the discharge can be blocked with the upper end portion 80i of the side wall portion 80b. Accordingly, the depth D1 of the concavity 80c greater than the thickness T3 of the package substrate 3b can prevent a short circuit between the light emitting device 3 and the base unit 1C more reliably.

According to the present embodiment, the insulation and heat radiation moulding 80 is integrally formed with no joint. Namely, the insulation and heat radiation moulding 80 is not provided with joints which are formed in a case where plural split parts are fixed together with an adhesive or the like. As a result, the light emitting device 3 and the base unit 1C can be prevented from being short-circuited via joints so as to prevent a short circuit therebetween more reliably.

The use of the heat radiator 70 having such a configuration can achieve a reduction in size (reduction in diameter) of the LED unit 100C used for a light fixture.

[Fifth embodiment]

An LED unit according to a fifth embodiment is explained in detail below with reference to the drawings. Note that the same elements as those in the fourth embodiment are indicated by the same reference numerals, and overlapping explanations thereof are not repeated below.

A heat radiator 70A used in the LED unit according to the present embodiment includes the base unit 1C and an insulation and heat radiation moulding 80A formed of the thermally conductive resin, as in the case of the fourth embodiment. As shown in Fig. 11, the insulation and heat radiation moulding 80A, in which the package substrate 3b of the light emitting device 3 is placed, is formed on the upper surface of the base unit 1C. Although Fig. 11 is illustrated with an example in which the base unit 1C is formed into a rectangular parallelepiped, the base unit 1C may be formed into any shape.

The insulation and heat radiation moulding 80A is formed of the thermally conductive resin as in the case of the fourth embodiment. The insulation and heat radiation moulding 80A is provided with the concavity 80c in which the light emitting device 3 is placed.

The insulation and heat radiation moulding 80A includes the bottom wall portion 80a having the rear surface (one surface) 80e attached to the base unit 1C and the front surface (the other surface) 80f on which the package substrate 3b of the light emitting device 3 is placed. The insulation and heat radiation moulding 80A further includes the side wall portion 80b projecting from the bottom wall portion 80a. The side wall portion 80b is provided in the entire circumference of the bottom wall portion 80a.

The rectangular bottom surface 80h of the concavity 80c has substantially the same size as the rear surface of the rectangular package substrate 3b in the plan view so that the entire circumference of the package substrate 3b is positioned by the side wall portion 80b. The depth D1 of the concavity 80c is greater than the thickness T3 of the package substrate 3b. The insulation and heat radiation moulding 80A is integrally formed with no joint.

The insulation and heat radiation moulding 80A of the heat radiator 70A is provided with a projection 80j projecting outward and formed in the side wall portion 80b. As shown in Fig. 11, the projection 80j of the present embodiment is formed into a flange projecting outward in the horizontal direction from the upper end portion 80i of the side wall portion 80b.

The present embodiment described above can achieve substantially the same operations and effects as those in the fourth embodiment. The insulation and heat radiation moulding 80A of the heat radiator 70A in the present embodiment includes the projection 80j projecting outward and formed in the side wall portion 80b, as described above. Accordingly, the sufficient distance along the surfaces between the package substrate 3b and the base unit 1C can be ensured while the height of the side wall portion 80b is decreased.

The projection 80j may be provided continuously in the entire circumference of the upper end portion 80i of the side wall portion 80b or may be provided at intervals along the upper end portion 80i. The projection 80j is not necessarily formed substantially into a rectangular shape in cross section, as shown in Fig. 11, as long as the distance along the surfaces can be increased, and may be formed into a semicircle or a polygonal shape such as a substantially triangular shape. Further, the projection 80j is not necessarily provided in the upper end portion 80i of the side wall portion 80b and may be, for example, formed in the middle of the side wall portion 80b. Alternatively, a plurality of projections 80j may be arranged in the vertical direction.

[Sixth embodiment]

An LED unit according to a sixth embodiment is explained in detail below with reference to the drawings. Note that the same elements as those in the fourth and fifth embodiments are indicated by the same reference numerals, and overlapping explanations thereof are not repeated below.

A heat radiator 70B used in the LED unit according to the present embodiment includes the base unit 1C and an insulation and heat radiation moulding 80B formed of the thermally conductive resin, as in the case of the fourth embodiment. As shown in Fig. 12, the insulation and heat radiation moulding 80B, in which the package substrate 3b of the light emitting device 3 is placed, is formed on the upper surface of the base unit 1C. Although Fig. 12 is illustrated with an example in which the base unit 1C is formed into a rectangular parallelepiped, the base unit 1C may be formed into any shape.

The insulation and heat radiation moulding 80B is formed of the thermally conductive resin as in the case of the fourth embodiment. The insulation and heat radiation moulding 80B is provided with the concavity 80c in which the light emitting device 3 is placed.

The insulation and heat radiation moulding 80B includes the bottom wall portion 80a having the rear surface (one surface) 80e attached to the base unit 1C and the front surface (the other surface) 80f on which the package substrate 3b of the light emitting device 3 is placed. The insulation and heat radiation moulding 80B further includes the side wall portion 80b projecting from the bottom wall portion 80a. The side wall portion 80b is provided in the entire circumference of the bottom wall portion 80a.

The rectangular bottom surface 80h of the concavity 80c has substantially the same size as the rear surface of the rectangular package substrate 3b in the plan view so that the entire circumference of the package substrate 3b is positioned by the side wall portion 80b. The depth D1 of the concavity 80c is greater than the thickness T3 of the package substrate 3b. The insulation and heat radiation moulding 80B is integrally formed with no joint. The present embodiment described above thus can achieve substantially the same operations and effects as those in the fourth embodiment.

In the present embodiment, the insulation and heat radiation moulding 80B of the heat radiator 70B includes at least one of a recessed surface 80m and a projecting surface 80n formed on an outer surface 80p of the side wall portion 80b. Fig. 12 is illustrated with an example in which a plurality of recessed surfaces 80m and a plurality of projecting surfaces 80n are alternately arranged in the vertical direction. Namely, the example is shown in which a plurality of recesses and projections are provided on the outer surface 80p of the side wall portion 80b. The recesses and projections (recessed surfaces 80m and projecting surfaces 80n) are formed in a manner such that the recessed surfaces 80m do not project from the outer surface of the side wall portion 80b. Thus, the side wall portion 80b can be prevented from projecting outward. Accordingly, a reduction in size of the heat radiator 70B in both the width direction and the height direction can be achieved.

The recessed surfaces 80m and the projecting surfaces 80n may be provided continuously in the entire circumference of the side wall portion 80b or may be provided at intervals along the circumference of the side wall portion 80b. The recessed surfaces 80m and the projecting surfaces 80n are not necessarily formed substantially into a rectangular shape in cross section, as shown in Fig. 12, as long as the distance along the surfaces can be increased, and may be formed into a semicircle or a polygonal shape such as a substantially triangular shape. Alternatively, the insulation and heat radiation moulding 80B may be provided with only one recessed surface 80m in the side wall portion 80b or only one projecting surface 80n in the side wall portion 80b. That is, at least one of the recessed surface 80m and the projecting surface 80n is only required to be formed on the outer surface 80p of the side wall portion 80b.

Although the present invention has been described above by reference to the respective embodiments, the present invention is not limited to the descriptions thereof, and it will be apparent to those skilled in the art that various modifications and improvements can be made. The respective configurations according to the first to sixth embodiments may be combined as appropriate.

The entire contents of Japanese Patent Application No. P2013-112782 (filed on May 29, 2013), Japanese Patent Application No. P2013-189347 (filed on September 12, 2013) and Japanese Patent Application No. P2013-216180 (filed on October 17, 2013) are herein incorporated by reference.

INDUSTRIAL APPLICABILITY

In the LED unit according to the respective embodiments, the base unit is formed of a molding in which a metal member is covered with thermally conductive resin. Thus, heat generated in the light emitting device can efficiently be radiated through the base unit toward a fixture to which the LED unit is attached. In addition, the metal member is covered with the thermally conductive resin having an electrical insulation property, and the thermally conductive resin is interposed between the light emitting device and the metal member. Accordingly, the electrical insulation property therebetween can be ensured without use of a conventional electrical insulating sheet.

REFERENCE SIGNS LIST

| | |
|---|---|
| 1, 1A, 1B, 1C | BASE UNIT |
| 1s | REAR SURFACE OF BASE UNIT |
| 3 | LIGHT EMITTING DEVICE |
| 3a | LIGHT EMITTING PORTION |
| 3b | PACKAGE SUBSTRATE |
| 11 | METAL MEMBER |
| 60 | THERMALLY CONDUCTIVE RESIN |
| 80, 80A, 80B | INSULATION AND HEAT RADIATION MOULDING |
| 80e | REAR SURFACE (ONE SURFACE) |
| 80f | FRONT SURFACE (OTHER SURFACE) |
| 80j | PROJECTION |

| 80m | RECESSED SURFACE |
| 80n | PROJECTING SURFACE |
| 80p | OUTER SURFACE |
| 100, 100A, 100B, 100C | LED UNIT |

**Claims**

1. An LED unit comprising:

   a base unit; and
   a light emitting device including: a package substrate; and a light emitting portion provided in the package substrate and having an LED chip, the light emitting device being placed on a front surface of the base unit, the base unit being formed of a molding in which a metal member is covered with thermally conductive resin having an electrical insulation property, the thermally conductive resin being interposed between the light emitting device and the metal member.

2. The LED unit according to claim 1, wherein the metal member is exposed on a rear surface of the base unit.

3. The LED unit according to claim 1 or 2, wherein thermal conductivity of the metal member is in a range of 50 to 400 W/m·K.

4. The LED unit according to any one of claims 1 to 3, wherein a breakdown voltage between the front surface and the rear surface of the base unit is 5 kV/mm or greater.

5. The LED unit according to any one of claims 1 to 4, wherein a Shore A hardness of the thermally conductive resin interposed between the light emitting device and the metal member is in a range of 10 or greater to less than 70.

6. The LED unit according to any one of claims 1 to 5, further comprising:

   an insulation and heat radiation moulding attached to the base unit to ensure electrical insulation between the light emitting device and the base unit, the insulation and heat radiation moulding being provided with a concavity in which the light emitting device is placed.

7. The LED unit according to claim 6, wherein a depth of the concavity is greater than a thickness of the package substrate.

8. The LED unit according to claim 6 or 7, wherein the insulation and heat radiation moulding is integrally formed with no joint.

9. The LED unit according to any one of claims 6 to 8, wherein
   the insulation and heat radiation moulding includes a bottom wall portion having one surface attached to the base unit and another surface on which the package substrate of the light emitting device is placed, and a side wall portion provided along a circumference of the bottom wall portion; and
   at least one of a recessed surface and a projecting surface is formed on an outer surface of the side wall portion.

10. The LED unit according to claim 9, wherein the package substrate is positioned by the side wall portion.

11. The LED unit according to claim 9 or 10, wherein the side wall portion is provided with a projection projecting outward.

# FIG. 1

FIG. 2

# FIG. 3

(a)

(b)

FIG. 4

(a)

(b)

FIG. 5

## FIG. 6

FIG. 7

(a)

(b)

FIG. 8

(a)

(b)

EP 3 006 825 A1

FIG. 9

FIG. 10

(a)

(b)

EP 3 006 825 A1

FIG. 11

FIG. 12

## INTERNATIONAL SEARCH REPORT

| International application No. |
| --- |
| PCT/JP2014/002762 |

**A. CLASSIFICATION OF SUBJECT MATTER**
*F21V29/00*(2006.01)i, *F21V19/00*(2006.01)i, *F21Y101/02*(2006.01)n

According to International Patent Classification (IPC) or to both national classification and IPC

**B. FIELDS SEARCHED**

Minimum documentation searched (classification system followed by classification symbols)
F21V29/00, F21V19/00, F21Y101/02

Documentation searched other than minimum documentation to the extent that such documents are included in the fields searched
Jitsuyo Shinan Koho        1922–1996    Jitsuyo Shinan Toroku Koho    1996–2014
Kokai Jitsuyo Shinan Koho   1971–2014    Toroku Jitsuyo Shinan Koho    1994–2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | JP 2012-182192 A  (Panasonic Corp.),<br>20 September 2012 (20.09.2012),<br>paragraphs [0021] to [0035]; fig. 1<br>(Family: none) | 1–5<br>6–11 |
| Y<br>A | WO 2012/101691 A1  (Panasonic Corp.),<br>02 August 2012 (02.08.2012),<br>paragraphs [0056] to [0066]; fig. 4<br>& JP 5015357 B1        & US 2012/0224381 A1<br>& CN 102725579 A | 1–5<br>6–11 |
| Y | JP 2010-262790 A  (Swan Lite Manufacturing Co.,<br>Ltd.),<br>18 November 2010 (18.11.2010),<br>paragraph [0033]<br>(Family: none) | 3 |

|☒| Further documents are listed in the continuation of Box C. | | ☐ | See patent family annex. |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    13 August, 2014 (13.08.14) | Date of mailing of the international search report<br>    26 August, 2014 (26.08.14) |
| --- | --- |
| Name and mailing address of the ISA/<br>    Japanese Patent Office | Authorized officer |
| Facsimile No. | Telephone No. |

Form PCT/ISA/210 (second sheet) (July 2009)

33

**INTERNATIONAL SEARCH REPORT**

International application No.

PCT/JP2014/002762

C (Continuation).　DOCUMENTS CONSIDERED TO BE RELEVANT

| Category* | Citation of document, with indication, where appropriate, of the relevant passages | Relevant to claim No. |
|---|---|---|
| Y | WO 2011/098463 A1 (DSM IP ASSETS B.V.), 18 August 2011 (18.08.2011), page 5, lines 26 to 32 & JP 2013-519972 A  & US 2013/0051011 A1 & EP 2534418 A1  & CN 102762920 A & KR 10-2012-0125490 A | 4 |
| Y | JP 2012-26171 A (Toli Corp., Assist Co., Ltd.), 09 February 2012 (09.02.2012), paragraph [0031] (Family: none) | 5 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012182192 A
- JP 2012133964 A
- JP 2012199256 A

- JP P2013112782 B
- JP P2013189347 B
- JP P2013216180 B